# EUROPEAN PATENT APPLICATION

(11) **EP 4 535 406 A1**
(43) Date of publication of application: **09.04.2025**
(21) Application number: 23816127.7
(22) Date of filing: 31.05.2023
(51) Int. Cl.: H01L 21/312, H01L 21/302, H01L 21/306

(54) **SUBSTRATE PROCESSING METHOD, AND SUBSTRATE MANUFACTURING METHOD**

(30) Priority: 02.06.2022 JP 2022090144
(71) Applicant: Central Glass Company, Limited, Ube-shi, Yamaguchi 755-0001 (JP)
(72) Inventor: OKUMURA, Yuzo, Tokyo 101-0054 (JP); TERUI, Yoshiharu, Tokyo 101-0054 (JP)
(74) Representative: Mewburn Ellis LLP
(86) International application number: PCT/JP2023/020356
(87) International publication number: WO 2023/234370

(57) **Abstract**

A substrate processing method according to the present invention incudes: a preparation step of preparing a substrate in which at least a first surface containing silicon oxide and a second surface containing silicon or a silicon compound other than silicon oxide are exposed; a surface modification step of forming an etching selectivity imparting film on at least a part of the first surface and at least a part of the second surface by a silylation treatment of bringing a silylating agent into contact with the first surface and the second surface; and an etching step of selectively carrying out an etching treatment on the second surface with respect to the first surface using an etching agent after the surface modification step.

## Description

### TECHNICAL FIELD

The present invention relates to a substrate processing method and a substrate manufacturing method.

### BACKGROUND ART

In the related art, fine patterning has been carried out by a plurality of lithography treatments or etching treatments in order to obtain a semiconductor device. However, in recent years, there has been a tendency for semiconductor devices to be more highly integrated and miniaturized, and there has been such a problem that, in a case where an attempt is made to satisfy these requirements, the lithography treatment tends to be complicated and costly. Therefore, there is a demand for an alternative technique as a substitute for the lithography technique.

As an alternative technique as a substitute for the lithography technique, a technique using a self-assembled monolayer (SAM) has been studied. Specifically, it is a technique of selectively depositing a self-assembled monolayer (hereinafter, simply referred to as a "monolayer") as a mask material or a protective material in a substrate region which is a non-treatment target, and subjecting a desired film material to a film formation or deposition in a remaining region (that is, a region which is a treatment target) of the substrate or carrying out an etching treatment.

Various methods have been studied as the method of selectively depositing the monolayer, and for example, there is a method of selectively forming a monolayer based only on the chemical properties of the surface of the substrate. In such a method, a combination of the non-treatment target and the treatment target is not particularly limited as long as the monolayer can be selectively formed. Therefore, various studies have been made on a method of forming a monolayer corresponding to such a combination. As such a technique, for example, techniques described in Patent Documents 1 to 3 are known.

For example, Patent Document 1 discloses a method of supplying a protective film forming gas including an amine gas to a substrate having a surface on which a first film and a second film having respective properties of being etched by an etching gas are formed, thereby adsorbing an amine on the first film to selectively protect the first film, and then selectively etching the second film. In the claims of this document, as the combination of the first film and the second film, each of a combination of a silicon oxide film and a silicon film and a combination of an SiOCN film and a silicon oxide film is disclosed, and as the protective film forming gas, hexylamine, dipropylamine, n-octylamine, butylamine, tert-butylamine, decylamine, dodecylamine, dicyclohexylamine, tetradecylamine, and the like are exemplified.

Patent Document 2 discloses a method of forming a SAM on vertical spacers as a blocking material and then selectively forming a high-k film on a nanowire between the vertical spacers and a metal-containing gate electrode layer on the high-k film. In this document, it is described that the vertical spacer includes a SiCOH material, a dielectric material having a relative dielectric constant of less than approximately 7, or an air gap spacer and that the nanowire is composed of Si, SiGe, or both of Si and SiGe. In addition, as a terminal group of a molecule that forms the SAM, thiol, silane, and phosphonate are exemplified.

Patent Document 3 discloses a method of forming a water repellent film by silylating a SiO₂ film surface using a substrate having a SiO₂ film and a SiN film, carrying out a silylation treatment on one SiN film so that the water repellent film is not formed, and then selectively etching the exposed SiN film (paragraph 0006 of Patent Document 3). Specifically, paragraph 0052 of Patent Document 3 describes that the SiN film (nitride film) does not have a hydroxyl group and thus does not react with a silylating agent.

### RELATED DOCUMENT

### PATENT DOCUMENT

Patent Document 1: PCT Japanese Translation Patent Publication No. 2021-163775
Patent Document 2: PCT Japanese Translation Patent Publication No. 2021-528859
Patent Document 3: Japanese Unexamined Patent Publication No. 2012-164949

### SUMMARY OF THE INVENTION

### TECHNICAL PROBLEM

The present invention aims to realize a substrate processing method which has favorable etching selectivity for a silicon nitride-containing second surface with respect to a silicon oxide-containing first surface and has excellent liquid draining properties.

### SOLUTION TO PROBLEM

According to one aspect of the present invention, there are provided a substrate processing method and a substrate manufacturing method, which are as follows.
1. A substrate processing method including:
   a preparation step of preparing a substrate in which at least a first surface containing silicon oxide and a second surface containing silicon or a silicon compound other than silicon oxide are exposed;
   a surface modification step of forming an etching selectivity imparting film on at least a part of the first surface and at least a part of the second surface by a silylation treatment of bringing a silylating agent into contact with the first surface and the second surface; and
   an etching step of selectively carrying out an etching treatment on the second surface with respect to the first surface using an etching agent after the surface modification step.
2. The substrate processing method according to 1.,
   in which the surface modification step such that a pretreatment is carried out before the silylation treatment, and
   in which the pretreatment includes a treatment of increasing a difference between a first water contact angle on the etching selectivity imparting film on the first surface and a second water contact angle on the etching selectivity imparting film on the second surface.
3. The substrate processing method according to 1. or 2.,
   in which in the preparation step, the substrate contains a silicon compound other than a silicon oxide on the second surface, and
   in which the etching step is carried out, after the surface modification step, without carrying out an oxidation treatment of bringing an oxidizing agent into contact with the second surface.
4. The substrate processing method according to 1. or 2.,
   in which in the preparation step, the substrate contains silicon on the second surface, and
   in which the etching step is a step of carrying out, after the surface modification step, an oxidation treatment of bringing an oxidizing agent into contact with the second surface and then carrying out the etching treatment.
5. The substrate processing method according to any one of 1. to 4., in which in the surface modification step, a first water contact angle on the etching selectivity imparting film on the first surface has a value larger than a value of a second water contact angle on the etching selectivity imparting film on the second surface.
6. The substrate processing method according to 5., in which a difference between the first water contact angle and the second water contact angle is 5° or more.
7. The substrate processing method according to any one of 1. to 6., further including:
   a cleaning step of subjecting the first surface and the second surface to a cleaning treatment using a cleaning agent, between the surface modification step and the etching step.
8. The substrate processing method according to 7., in which a liquid temperature of the cleaning agent is 60°C or lower.
9. The substrate processing method according to 7. or 8., in which the cleaning agent includes an aqueous cleaning solution and/or a rinsing solution.
10. The substrate processing method according to any one of 7. to 9., in which a cycle including at least the surface modification step, the cleaning step, and the etching step in this order is carried out two or more times.
11. The substrate processing method according to any one of 1. to 10., further including: a removal treatment of removing at least a part of the etching selectivity imparting film on the first surface, after the etching step.
12. The substrate processing method according to any one of 1. to 11., in which a cycle including at least the surface modification step and the etching step in this order is carried out two or more times.
13. The substrate processing method according to any one of 1. to 12., in which in the silylation treatment, the etching selectivity imparting film is formed using a silylation composition containing the silylating agent and a catalytic compound.
15. A substrate manufacturing method including:
   each step in the substrate processing method according to any one of 1. to 13.

### ADVANTAGEOUS EFFECTS OF INVENTION

According to the present invention, there are provided a substrate processing method which has favorable etching selectivity for a silicon nitride-containing second surface with respect to a silicon oxide-containing first surface and has excellent liquid draining properties, and a substrate manufacturing method using the substrate processing method.

### BRIEF DESCRIPTION OF THE DRAWINGS

Fig. 1 is a step cross-sectional view schematically showing each step of a substrate processing method according to the present embodiment.
Fig. 2 is a step cross-sectional view schematically showing each step of the substrate processing method according to the present embodiment.
Fig. 3 shows an example of a process flow of the substrate processing method according to the present embodiment.

### DESCRIPTION OF EMBODIMENTS

Hereinafter, embodiments of the present invention will be described with reference to the drawings. It is noted that in all the drawings, the same constitutional elements are denoted as the same reference numerals and explanations thereof will not be repeated, as appropriate. In addition, the figures are schematic views and do not correspond to the actual dimensional ratios.

### <Substrate processing method>

An outline of the substrate processing method according to the present embodiment will be described.

The substrate processing method according to the present embodiment includes a preparation step of preparing a substrate in which at least a first surface containing silicon oxide and a second surface containing silicon nitride are exposed; a surface modification step of forming an etching selectivity imparting film on at least a part of the first surface and at least a part of the second surface by a silylation treatment of bringing a silylating agent into contact with the first surface and the second surface; and an etching step of selectively carrying out etching on the second surface with respect to the first surface using an etching agent after the surface modification step.

According to the knowledge of the inventors of the present invention, it is possible to form a film (etching selectivity imparting film) that imparts favorable etching selectivity for a second surface containing silicon nitride with respect to a first surface containing silicon oxide by using a difference in ease of reaction with a silylating agent. As a result, it was found that it is possible to impart the etching selectivity for the second surface with respect to the first surface, and it is possible to increase the liquid draining properties on the first surface and the second surface as compared with a case where the silylation treatment is not carried out.

By increasing the liquid draining properties, liquid draining in a cleaning process, a drying process, or the like can be promoted.

It is noted that the term "etching selectivity" in the present specification refers to that in an etching step, a function is provided to satisfy; etching amount of first surface < etching amount of second surface.

In addition, silicon or a silicon compound other than silicon oxide (for example, silicon nitride, silicon (polysilicon), silicon germanium, or the like) is easily subjected to an etching treatment by being oxidized.

According to further studies of the inventors of the present invention, it has been found that, in a case of being brought into contact with an oxidizing agent described later, the etching selectivity imparting film formed on the first surface is maintained, and the second surface is oxidized even in a case where the etching selectivity imparting film is formed on the second surface. As a result, by using, before the etching treatment, the above-described oxidation treatment using an oxidizing agent, the second surface can be suitably selectively etched even in a case where the second surface is other than silicon nitride.

It is noted that in the "etching selectivity imparting film" or the "water repellent film" in the present specification, both a compound having a silyl group derived from a silylating agent, which has been chemically bonded to a surface having a silicon element, and a group of such compounds are referred to, and the presence or absence of interaction between the compounds or the presence or absence of bonding between the compounds does not matter. In addition, the above-described water repellent film may contain a compound derived from a silylating agent, which has been subjected to physical binding (adsorption, attachment, or the like) to the surface having the silicon element. It is noted that the above-described binding is not required to be a direct bonding and includes a case of bonding through another element, a substituent, or the like.

### (Water repellency)

For the water repellency in the present specification, a water contact angle obtained by the following measurement is used. It is noted that details of the cleaning, drying, or the like before each measurement will be described later.

First, a substrate was placed horizontally such that a desired smooth surface having a silicon element was facing upward, and 2 µl of a water droplet of pure water was placed on the surface. Next, in accordance with JIS R 3257:1999 "Testing method of wettability of surface of glass substrate", an angle formed by a water droplet and the substrate was measured with a contact angle meter (manufactured by Kyowa Interface Science Co., Ltd.: CA-X type), and the obtained value was defined as a water contact angle. In addition, the temperature during the measurement was set to room temperature (25°C).

### (Liquid draining properties)

For the liquid draining properties in the present specification, water receding angle which is obtained by subjecting a smooth substrate immediately before an etching treatment to the following measurement is used. In a case where the water receding angle was 10° or more, the liquid draining properties were evaluated to be good, and in a case where the water receding angle was less than 10°, the liquid draining properties were evaluated to be bad.

First, the substrate was placed horizontally such that the surface subjected to the silylation treatment was upward, and 30 µl of pure water was dropped thereon at a room temperature of 25°C. Next, the pure water was sucked at a rate of 6 µl/sec, an angle formed by the water droplet and the substrate while the size of the liquid droplet was being reduced was measured with the contact angle meter, and the value was defined as a water receding angle (°).

Hereinafter, each step included in the substrate processing method will be described in detail.

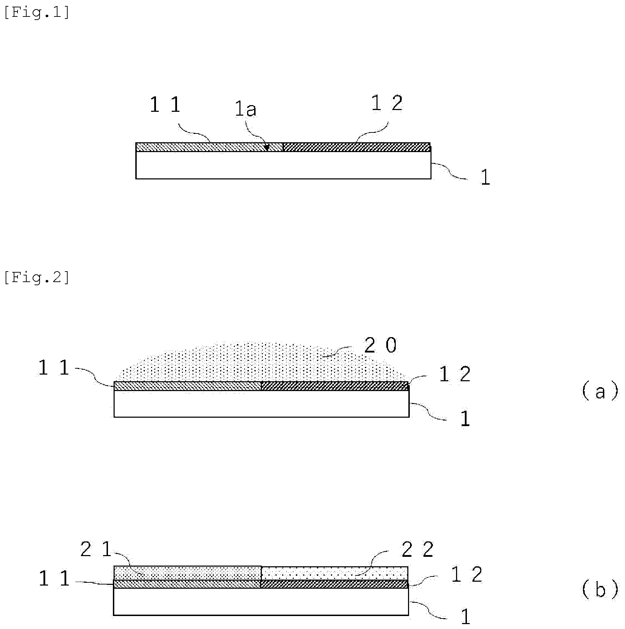

An example of the substrate processing method according to the present embodiment includes a preparation step, a surface modification step, and an etching step, which will be described with reference to Fig. 1 and Fig. 2. Fig. 1 and Fig. 2 are each a step cross-sectional view schematically showing each of the steps of the substrate processing method.

### (Preparation step)

As shown in Fig. 1, in the above-described preparation step, a substrate 1 having a first surface 11 and a second surface 12 on the surface is prepared.

A material of the substrate 1 is not particularly limited as long as it is a substrate that is used in a semiconductor manufacturing process. The material of the substrate 1 may be composed of, for example, silicon, silicon carbide, a plurality of components containing a silicon element, sapphire, various compound semiconductors, or the like. In addition, the substrate 1 may be, for example, a wafer.

The substrate 1 may have an uneven structure (not shown in the drawing) formed on the substrate surface.

The uneven structure may be composed of a three-dimensional structure having, for example, one or two or more structural bodies disposed along a vertical direction of a substrate surface 1a and/or one or two or more structural bodies disposed along a horizontal direction orthogonal to the vertical direction. As an example, such a three-dimensional structure may constitute at least a part of a logic device, a memory device, a gate electrode, or the like, and examples thereof include a FinFET, a nanowire FET, a nanosheet FET, or another multi-gate type FET, and a three-dimensional memory cell.

Each of the first surface 11 and the second surface 12 may be disposed along the plane direction of the substrate surface 1a; however, it may be disposed along a direction perpendicular to the substrate surface 1a. According to the present embodiment, it is possible to carry out not only a two-dimensional selective processing treatment on a plane but also a three-dimensional selective processing treatment on a three-dimensional structure (three-dimensional film formation, three-dimensional etching, or the like).

The first surface 11 and the second surface 12 may be formed to be adjacent to each other; however, they may be formed to be spaced from each other. Each of the first surface 11 and the second surface 12 may be composed of one region or a plurality of two or more regions. On each surface, a plurality of regions may be formed to be spaced apart from each other.

The first surface 11 contains silicon oxide. The other second surface 12 contains a silicon compound other than silicon oxide, or silicon.

The silicon in the present specification is single crystal silicon or polysilicon. In addition, the silicon compound other than silicon oxide may be a compound formed between at least one element selected from the group consisting of an N element, a C element, and a metal element, and a Si element.

The metal element may be any metal element as long as it is a metal element or a metalloid element, which is usually used in a semiconductor material, and examples thereof include W, Co, Al, Ni, Ru, Cu, Ge, Ti, Hf, and Ta. In addition, examples of the silicon compound having an N element and/or a C element include compounds such as silicon nitride, silicon carbide, and silicon carbonitride, and compounds formed between these compounds and the above metal elements.

Among these, from the viewpoint of ease of etching treatment, it is preferable to contain a silicon compound having an N element, such as silicon nitride. In addition, in a case where an oxidation treatment described later is carried out before the etching treatment, the second surface 12 preferably contains silicon or a compound formed between at least one element selected from the group consisting of an N element, a C element, and a metal element, and a Si element, and more preferably contains silicon or a silicon compound having at least one of a C element or a metal element.

It is noted that in a case where a naturally oxidized second surface 12 is brought into contact with a silylating agent after removing the oxygen element derived from the natural oxidation in the surface modification step described later, the naturally oxidized surface may be used in the preparation step as a surface in a state of not being naturally oxidized (for example, the naturally oxidized silicon surface may be prepared as the silicon surface).

The first surface 11 and the second surface 12 may be a surface of a member composed of the above material, or may be composed of a surface of a film composed of the above material (for example, a film containing an oxide of Si or a film containing a nitride of Si).

In addition, the surface may contain an element other than the above-described elements as long as the element does not affect the silylation. Examples thereof include H, O, N, C, P, B, and Al.

It is noted that the composition of the above-described film is merely described representatively, and the stoichiometric ratio thereof is not necessarily the integer ratio as described. Specifically, it is not limited to Si:O = 1:1 or Si:N = 1:1.

The water repellency of each of the first surface 11 and the second surface 12 is usually a property peculiar to the composition material constituting the surface; however, it can be adjusted by a pretreatment, a silylation treatment, or the like, which will be described later. For example, in a case where the silylation treatment is carried out, the original water repellency (water contact angle or the like) tends to be improved. In addition, the effect of the silylation treatment can be enhanced or weakened by the pretreatment. The above-described tendency varies depending on the composition material constituting the surface. Therefore, a desired etching selectivity imparting film (water repellent film) can be formed by considering the combination of the respective treatments and the water repellency immediately after these treatments. It is noted that even in a case where a water repellent film is formed on the surface by the silylation treatment of the first surface 11 or the second surface 12 and "the water repellency of the surface" actually means "the water repellency of the water repellent film", it is described as "the water repellency of the first surface" or "the water repellency of the second surface".

It is noted that a trace amount of one kind or two or more kinds of dopants (for example, P, N, B, Al, and the like) that is used for an n-type source drain or a p-type source drain may be contained in the first surface 11 and the second surface 12 or in the substrate 1 in the lower peripheral region of each of the first surface 11 and the second surface 12. Since the addition of a trace amount of the above-described dopant with respect to the content of the Si element can affect the electrical properties, it is presumed that any content at a level that allows a function as a dopant does not affect the silylation on the first surface 11 or the second surface 12.

The substrate 1 may further include a third surface and/or a fourth surface (not shown in the drawing) on the substrate surface 1a.

The third surface is a surface which contains Si and is composed to have a chemical composition different from those of the first surface 11 and the second surface 12.

The fourth surface is a surface that does not contain Si, and it is, for example, a surface composed of amorphous carbon, an element such as W, Co, Al, Ni, Ru, Cu, Ti, or Ta, or a compound, oxide, nitride, or the like of these elements. The fourth surface may be a film surface of a High-k film.

Each of the third surface and the fourth surface may be adjacent to each other, or the third surface and the fourth surface may be formed to be spaced from each other with respect to the first surface 11 and/or the second surface 12. In addition, each of the third surface and the fourth surface may be composed of one region or a plurality of two or more regions.

### (Surface modification step)

The surface modification step includes a silylation treatment of the substrate surface. As described above, by the silylation treatment, the etching selectivity imparting films (water repellent film 21 and water repellent film 22) can be formed on the first surface 11 and the second surface 12 of the substrate, respectively. In other words, it is possible to, after gently improving the water repellency of the second surface 12, improve the water repellency of the first surface 11 to be higher than the water repellency of the second surface 12.

In this case, in order to allow the water repellency of the first surface 11 and the second surface 12 to be a desired water repellency, a separate treatment such as a pretreatment may be carried out before and after the silylation treatment.

An example of the above-described surface modification step includes subjecting the substrate 1 shown in Fig. 1 to a pretreatment and then subjecting the substrate 1 to a silylation treatment as shown in Fig. 2.

In the present specification, pretreatment / silylation treatment may be respectively referred to as pretreatment A / silylation treatment B, or treatment A / treatment B.

It is noted that a part or all of these treatments A to B may be carried out by a wet process. In addition, the treatment A and the treatment B described above may be such that the first surface 11 and the second surface 12 are treated separately or may be treated at the same time; however, it is convenient to carry out the treatments simultaneously as shown in Fig. 1, which is preferable.

In addition, in a case where favorable results are obtained by the silylation treatment B even without carrying out the pretreatment A, the pretreatment A may not be carried out.

In a case where the pretreatment A is carried out before the silylation treatment B, the surface modification step may include, as the pretreatment A, a treatment of increasing a difference between a first water contact angle on the etching selectivity imparting film (water repellent film 21) on the first surface 11 and a second water contact angle on the etching selectivity imparting film (water repellent film 22) on the second surface 12.

Specific examples of the pretreatment A may include a treatment A-1 of removing at least a part of the natural oxidation film on the surface and/or a treatment A-2 of bonding OH to at least a part of Si elements on the surface.

It suffices that the pretreatment A is carried out on at least the first surface 11; however, it may be carried out on the first surface 11 and the second surface 12.

The treatment A-1 is not particularly limited as long as it is a treatment that is capable of removing the natural oxidation film. In general, in a semiconductor manufacturing process, a natural oxidation film is formed on a surface of silicon oxide or the like. This natural oxidation film can be removed by the treatment A-1, which is preferable. It is noted that although it is not necessary to carry out the treatment A-1 in a case of a surface on which the natural oxidation film is not formed, the operation of the treatment A-1 may be carried out as a part of the cleaning.

Specific examples of the treatment A-1 include a method in which hydrogen fluoride (HF) is brought into contact with the first surface 11 and the second surface 12, and a method in which a diluted hydrogen fluoride aqueous solution, that is, hydrofluoric acid (DHF), is brought into contact with the first surface 11 and the second surface 12. The specific method for contacting may be a publicly known method, and examples thereof include the same method as the silylation treatment B described later. It is noted that, after the treatment A-1, a cleaning treatment may be carried out with a cleaning agent described later before the silylation treatment B.

The treatment A-2 is not particularly limited as long as it is a method of forming an OH group on the surface of the first surface 11, and examples thereof include a method of bringing an oxidizing agent containing an oxygen element into contact with at least the first surface 11. In addition, within a range in which the etching selectivity is not impaired, the second surface 12 may be also subjected to the treatment A-2 during the treatment of the first surface 11. The OH group is less likely to be formed on the second surface 12 than on the first surface 11. However, in a case where the oxidizing power due to the treatment A-2 is strong, the OH group is excessively formed on the second surface 12, and thus the water repellency obtained by the subsequent silylation treatment B may not be within a desired range. Therefore, as the oxidizing agent that is used in the treatment A-2, it is desirable to use an oxidizing agent that can easily adjust the oxidizing power.

As the above-described oxidizing agent, a liquid oxidizing agent is preferably used since the strength of the oxidation can be easily adjusted. Examples of the liquid oxidizing agent described above include a solution containing H₂O₂ and/or ozone water. In addition, examples of the solution containing H₂O₂ include such a cleaning agent that is used for cleaning a silicon wafer or the like (an alkaline mixed liquid of H₂O₂ and ammonium hydroxide (SC-1 solution), an acidic mixed liquid of H₂O₂ and hydrochloric acid (SC-2 solution), or the like) and an H₂O₂ aqueous solution. In addition, a gas containing an oxygen element may be used as the oxidizing agent as long as the OH group is not excessively formed on the second surface 12. The specific method for contacting may be a publicly known method, and examples thereof include the same method as the silylation treatment B described later.

It is noted that, as necessary, the treatment A-1 may be carried out before the treatment A-2 to remove the natural oxidation film in advance. In addition, after the treatment A-2, a cleaning treatment may be carried out with a cleaning agent described later before the silylation treatment B.

As shown in Fig. 2(a), the silylation treatment B is a treatment of bringing a silylating agent described later into contact with at least the first surface 11 and the second surface 12. In the silylation treatment B, the silylating agent may be used alone; however, it is possible to use a silylation composition containing a silylating agent and a solvent or a dilution gas, or a silylation composition containing a silylating agent and a catalytic compound. The silylating agent or the silylation composition can be used in a liquid or gaseous state. From the viewpoint that the water repellency of the first surface 11 and the second surface 12 is easily improved, it is preferable that a silylation composition containing a silylating agent and a catalytic compound is supplied in a liquid form.

In a case of the wet process, a liquid of a silylating agent 20 or a liquid of a silylation composition 20 is supplied to the first surface 11 and the second surface 12. As the supply method, a publicly known means can be used, and examples thereof include, in a case of supply in a liquid state, a sheet feeding method such as a spin coating method, and a batch method such as an immersion method. In this case, the liquid temperature of the silylation composition 20 or the silylating agent 20 may be any temperature lower than the boiling point of the silylating agent, and it may be, for example, 10°C to 60°C. In addition, it is preferably 10°C to 30°C and more preferably 10°C to 29°C.

In addition, in a case where a vapor is supplied and then made into a liquid after being brought into contact with the first surface 11 and the second surface 12, a publicly known vapor jetting method can be used.

In a case of a dry process, the silylating agent is supplied to the first surface 11 and the second surface 12 as a gas. As the supply method, a publicly known means can be used, and examples thereof include a method of gasifying the silylating agent in advance using a vaporizer or the like and then supplying the gas, and a method of allowing the silylating agent to flow simultaneously together with an inert gas such as N₂ and Ar, thereby being accompanied and supplied. In addition, two or more kinds of gases may be simultaneously supplied or may be mixed in advance and then supplied.

The water repellency of the first surface 11 and the second surface 12 can be improved by the silylation treatment B; however, the water repellency of the first surface 11 becomes relatively higher than the water repellency of the second surface 12.

By the above-described silylation treatment B, a structure in which the silyl group derived from the silylating agent is chemically bonded to the OH group of the first surface 11, that is, a water repellent film is formed on the first surface 11, and the water repellency is improved. In addition, a water repellent film is also formed on the second surface 12, although the water repellency thereof is not as high as that of the first surface 11.

As an example, as shown in Fig. 2(b), a water repellent film 21 may be formed on the first surface 11, and a water repellent film 22 may be formed on the second surface 12. Each of the water repellent film 21 and the water repellent film 22 may be composed of a film that covers at least a part or the entire surface.

In a case where the point for reaction with a silylating agent can be increased on the first surface 11 by the pretreatment A as compared with the second surface 12, the silylation reaction on the first surface 11 can be relatively promoted in the silylation treatment B.

In a case of the wet process, the surface of the second surface 12 may be also slightly oxidized in a case of being treated in air containing oxygen. Therefore, it is considered that an OH group (Si-OH bond) which is a point for reaction with a silylating agent is generated. Since the OH group on the second surface 12 can be removed by the pretreatment A-1 described above, the reaction between the second surface 12 and the silylating agent can be suppressed. This makes it possible to relatively promote the silylation reaction on the first surface 11.

In addition, by increasing the Si-OH bond (OH group) on the first surface 11 through the pretreatment A-2 or the like, it is possible to form a water repellent film more easily, which is suitable. In this case, as described above, it is possible to suppress the formation of the OH group on the second surface 12, by adjusting the oxidizing power.

As necessary, a publicly known means such as a heating treatment, a decompression treatment, and a drying treatment may be applied to the silylation treatment B to promote the silylation reaction between the silylating agent and the OH group of the surface.

In addition, it is preferable to carry out each treatment so that Q1 > Q2 is satisfied in a case where a value (°) of the first water contact angle on the first surface 11 is denoted as Q1 and a value (°) of the second water contact angle on the second surface 12 is denoted as Q2, where these values are values after the surface treatment step, in other words, immediately before the etching step.

As the above-described difference is larger, the water repellency of the first surface 11 with respect to the water repellency of the second surface 12 is higher. Therefore, it is considered that an etching selectivity imparting film having excellent etching selectivity is formed on at least the first surface 11.

In addition, the difference between Q1 and Q2 is preferably 5° or more, more preferably 10° or more, and still more preferably 20° or more. In a case where it is set in the above-described range, it is easy to improve the etching selectivity in the etching step described later.

In addition, Q1 is preferably 65° or more. In a case where it is set in the above-described range, it is easy to improve the etching selectivity. It may be more preferably set to 70° or more and still more preferably set to 75° or more. In addition, in a case where Q1 is 88° or more, the first surface 11 can be protected from the etching treatment even in a case where the etching time is 5 minutes, which is preferable. In addition, Q2 is not particularly limited as long as it satisfies Q1 > Q2 and is a value that does not impair the etching selectivity. However, in a case where it is, for example, less than 63°, it is easy to improve the etching selectivity, which is preferable. It may be more preferably set to 60° or less and still more preferably set to 58° or less. The lower limit value of Q2 is not particularly limited; however, it may be set to, for example, 10° or more, and it may be set to preferably 20° or more, more preferably 30° or more, and still more preferably 40° or more.

In addition, in a case where the first surface 11 and the second surface 12 are simultaneously subjected to the surface modification treatment, as the value of Q1 increases, the value of Q2 also tends to increase, and thus in this case, the etching selectivity may be decreased. For example, it is preferable to carry out the surface modification treatment such that Q2/Q1 < 0.75 is satisfied. In addition, 0.70 or less is more preferable, and 0.68 or less is still more preferable. The lower limit thereof is not particularly limited; however, it may be, for example, 0.05 or more. In a case where the value of Q2/Q1 is higher than the value described above, the etching selectivity may be improved by carrying out an oxidation treatment before the etching treatment described later.

The surface modification step may include, as necessary, a cleaning step of carrying out a cleaning treatment of cleaning at least a part of the second surface 12 or the water repellent film 22 formed on the second surface 12, by using a cleaning agent. For example, the cleaning treatment may be carried out between the surface modification step and the etching step; however, the present disclosure is not limited thereto. By using the cleaning agent, it is possible to wash away the impurities and the unreacted silylating agent that have adhered to the first surface 11, the second surface 12, and the like.

In addition, in a case where at least a part of the treatment A and the treatment B is carried out by a wet process, one or two or more times of cleaning treatments can be carried out between the respective treatment A and treatment B or between the individual treatments included in the treatment A and the treatment B. In a case of a plurality of cleaning treatments, the kind of cleaning agent may be changed for each cleaning treatment.

The cleaning agent may contain an aqueous cleaning solution and/or a rinsing solution.

The aqueous cleaning solution may be any solution as long as it does not remove the water repellent film 21 formed on the first surface 11 and is not particularly limited. Examples thereof include water, an alcohol, a hydrogen peroxide aqueous solution, and ozone water. These may be used alone, or two or more thereof may be used in combination.

Similar to the case of the aqueous cleaning solution, the rinsing solution may be any solution as long as it does not remove the water repellent film 21 formed on the first surface 11 and is not particularly limited. As the rinsing solution, it is possible to use a cleaning agent different from the aqueous cleaning solution and examples thereof include water, an organic solvent, a mixture thereof, or a cleaning agent obtained by mixing at least one kind of an acid, an alkali, a surfactant, and an oxidizing agent in water, an organic solvent, a mixture thereof.

Examples of the organic solvent used in the rinsing solution include hydrocarbons, esters, ethers, ketones, halogen element-containing solvents, sulfoxide-based solvents, alcohols, polyhydric alcohol derivatives, and nitrogen element-containing solvents. Among the above, it is preferable to use, as an organic solvent, at least one kind selected from alcohols having 3 or less carbon atoms, such as methanol, 1-propanol, and 2-propanol (isopropanol).

A liquid temperature of the cleaning agent is not particularly limited; however, it may be, for example, 60°C or lower, 40°C or lower, or 30°C or lower. This makes it possible to suppress a decrease in the water repellency on the surface subjected to the silylation treatment.

In the present embodiment, the method of bringing the cleaning agent into contact is not particularly limited, and examples thereof include an immersion method, a coating method such as spin coating or spray coating, and vapor contacting.

In the surface modification step, a drying treatment may be carried out as necessary.

In addition, in a case where at least a part of the treatment A and the treatment B is carried out by a wet process, one or two or more times of drying treatments can be carried out between the respective treatment A and treatment B or between the individual treatments included in the treatment A and the treatment B.

### (Etching step)

In the etching step, the second surface 12 shown in Fig. 2(b) is selectively subjected to an etching treatment after the surface modification step. In addition, an oxidation treatment which will be described later may be carried out before the etching treatment.

In a case where an etching treatment is carried out, the etching of the first surface 11 is suppressed; however, the etching treatment proceeds on the second surface 12 as compared with on the first surface 11. Therefore, the second surface 12 can be selectively subjected to the etching treatment with respect to the first surface 11.

Although the detailed mechanism is not clear, it is presumed that the etching of the first surface 11 is suppressed as compared with the etching of the second surface 12 since the water repellent film 21 on the first surface 11 plays a role such as a shielding material for the etching agent.

### (Oxidation treatment)

The oxidation treatment is carried out before the etching treatment. As a result, at least a part of the second surface 12 after the surface modification step is oxidized, and the oxidized second surface 12 is easily subjected to the etching treatment, which makes it possible to increase the etching selectivity. In particular, it is suitable in a case where the second surface 12 has silicon or a compound formed between Si and at least one selected from the group consisting of C and a metal element.

In the oxidation treatment, the second surface 12 after the surface modification step is brought into contact with an oxidizing agent to oxidize at least a part of the second surface 12. In this case, by adjusting the oxidation treatment to such an extent that the etching selectivity of the etching selectivity imparting film on the first surface 11 is not significantly impaired, it is possible to bring simultaneously the first surface 11 and the second surface 12 after the surface modification step into contact with an oxidizing agent. For example, the treatment may be such that the water contact angle on the water repellent film 21 on the first surface 11 according to the present disclosure is 65° or more even after the oxidation treatment. In a case where it is set in the above-described range, it is easy to improve the etching selectivity. It may be more preferably set to 70° or more and still more preferably set to 75° or more.

It is noted that although at least a part of the second surface 12 is silicon oxide in a case where the second surface 12 is subjected to the oxidation treatment, the silicon oxide in this case is a precursor to be removed by the etching treatment, and thus the precursor formed on the second surface 12 by the oxidation treatment is treated as the second surface 12.

The oxidizing agent to be used may be any oxidizing agent as long as the etching selectivity on the first surface 11 is not impaired, and a liquid oxidizing agent that is the same as the liquid oxidizing agent in the treatment A-2 described above can be used. Examples thereof include a solution containing H₂O₂, and/or ozone water. In addition, examples of the solution containing H₂O₂ include such a cleaning agent that is used for cleaning a silicon wafer or the like (an alkaline mixed liquid of H₂O₂ and ammonium hydroxide (SC-1 solution), an acidic mixed liquid of H₂O₂ and hydrochloric acid (SC-2 solution), or the like) and an H₂O₂ aqueous solution. It suffices that these oxidizing agents are subjected to being brought into contact at a concentration of such an extent that the etching selectivity on the first surface 11 is not impaired. The specific method for contacting may be a publicly known method, and examples thereof include the same method as the silylation treatment B described above. In addition, after the above-described oxidation treatment is carried out, a cleaning treatment or a drying treatment may be carried out.

In addition, in a case of carrying out the oxidation treatment, a silylating agent may unintendedly react with an oxidizing agent in a case where the silylating agent remains on the substrate in some kind of state. Therefore, it is desirable to carry out the cleaning step at least once after the silylation treatment B in the surface modification step. In addition, as described above, since the first surface 11 and the second surface 12 after the surface modification step have favorable liquid draining properties, the cleaning step can be suitably carried out.

The etching treatment is not particularly limited as long as it is a method that is capable of etching the second surface 12, and a publicly known dry etching method or wet etching method can be selected.

In addition, it is preferable that various etching treatments are carried out using an etching agent. In a case of a gas, examples thereof include an HF gas, an HCl gas, a Cl₂ gas, an F₂ gas, an inter-halogen gas (for example, a ClF₃ gas, an IF₇ gas, or the like), and a gas including a mixed gas of these various gases. In addition, in a case of a liquid, examples thereof include a liquid obtained by diluting at least any one of HF, NH₄F, NH₄HF₂, H₃PO₄, or H₂SO₄ with a solvent. In addition, as the etching agent, such as one that is heated or is made into a plasma state or a radical state may be used.

After the above-described etching step, in a case where the water repellent film 21 (etching selectivity imparting film) remaining on the first surface 11 is unnecessary, a removal treatment of removing at least a part of the water repellent film 21 may be carried out. The removal method is not particularly limited as long as it is a method that is capable of removing a publicly known silylated group.

Examples thereof include light (ultraviolet rays) irradiation, heat treatment, ozone exposure, plasma irradiation, and corona discharge. In addition, the removal by a wet process is also possible, and examples thereof include contacting with an aqueous ammonium hydroxide solution, an aqueous tetramethylammonium solution, an aqueous hydrochloric acid solution, an aqueous sulfuric acid solution, or the like. In addition, by appropriately controlling the etching conditions, the etching agent used in the etching step may be used in the above-described removal treatment. As a result, the process can be simplified.

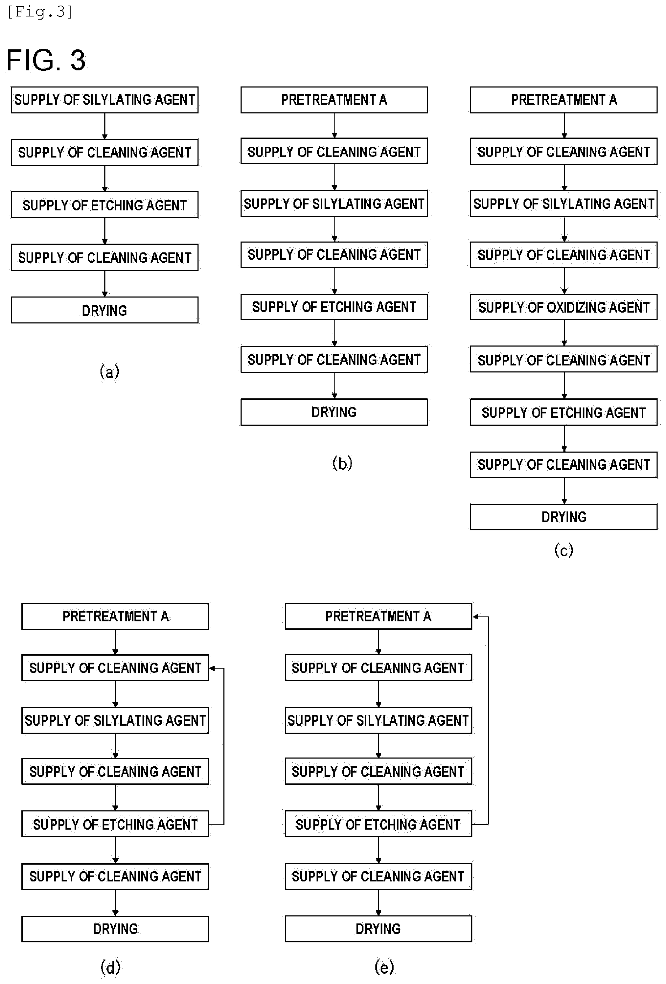

Figs. 3(a) to 3(e) show process flowcharts of an example of the substrate processing method according to the present embodiment. It is noted that the present invention is not limited to the following process flow.

In the substrate processing method of Fig. 3(a), the silylation treatment as a surface treatment step, and the etching treatment as an etching step are carried out in this order.

In the substrate processing method of Fig. 3(b), the pretreatment A and the silylation treatment as a surface treatment step, and the etching as an etching step are carried out in this order.

In the substrate processing method of Fig. 3(c), the pretreatment A and the silylation treatment as a surface treatment step, and the oxidation treatment and the etching as an etching step are carried out in this order.

It is noted that a cleaning treatment can be carried out, as necessary, between the respective treatments of Figs. 3(a) to 3(c). In addition, Fig. 3(c) shows a flow including the pretreatment A; however, the flow may be such that the pretreatment A is not carried out.

It is noted that in the substrate processing method, a cycle including at least the surface modification step and the etching step in this order may be carried out two or more times. In addition, in the substrate processing method, a cycle including at least the surface modification step, the cleaning step, and the etching step in this order may be carried out two or more times. With such a cyclic process, it is possible to increase the etching amount while maintaining the effect of the etching selectivity.

In another embodiment, in the substrate processing method in which the above-described cycle is carried out two or more times, the same silylation treatment is continued to allow the refinement of the first surface 11 to proceed. Therefore, the time for the n-th silylation treatment may be shorter than the time for the (n-1)-th silylation treatment. Here, n is an integer of 2 or more. It is noted that the silylation treatment having a reduced time may be only for the second treatment, may be for all the second and subsequent treatments, or may be for at least one treatment of the second and subsequent treatments.

In addition, in the substrate processing method in which the above-described cycle is carried out two or more times, the first surface treatment step may include the pretreatment; however, at least one of the second and subsequent surface modification steps may not include the pretreatment.

Fig. 3(d) shows an example of a process flow of this cycle. In a case where both the pretreatment A and the etching treatment are any one of the oxidative treatment or the non-oxidative treatment, the etching treatment serves as the pretreatment A, and thus the second and subsequent pretreatments A can be omitted.

In addition, Fig. 3(e) shows an example of a process flow of this cycle in another embodiment. In a case where one of the pretreatment A or the etching treatment is the oxidative treatment and the other is the non-oxidative treatment, it is preferable to carry out the cleaning treatment before the pretreatment A after the etching treatment.

It is noted that examples of the "oxidative treatment" include a treatment in a case of being carried out using a material used in the pretreatment A-2, the oxidation treatment, or the like, and an etching treatment accompanied by oxidation. Examples of the term "non-oxidative treatment" include a treatment in a case of being carried out using a material used in the pretreatment A-1, and an etching treatment that is not accompanied by oxidation.

The substrate manufacturing method according to the present embodiment includes a step of obtaining a substrate that has been substrate processing method to each step in the above-described substrate processing method. A desired semiconductor wafer or a desired semiconductor device can be obtained by the substrate manufacturing method.

### <Silylating agent>

A silylating agent that is used in the silylation treatment in the above-described substrate processing method, and a silylation composition containing the silylating agent will be described.

As the silylating agent, a publicly known silylating agent can be used.

Examples of the silylating agent include a silicon compound represented by General Formula [1]. These may be used alone, or two or more thereof may be used in combination. In a case of using two or more kinds thereof in combination, it may be described as a "silylation composition". In addition, in a case where two or more kinds thereof are combined, silicon compounds represented by General Formula [1], in which R¹'s have the same number of carbon atoms with each other, may be used in combination, or silicon compounds represented by General Formula [1], in which R¹'s have the numbers of carbon atoms different from each other, may be used in combination.

R¹ₐSi(H)_{b}X_{4-a-b} [1]

In General Formula [1], R¹'s each independently represent an organic group including a hydrocarbon group having 1 to 18 carbon atoms, in which a part or all of hydrogen elements may be substituted with a fluorine element, X's each independently represent a monovalent organic group in which an element bonded to a Si element is nitrogen, oxygen, carbon, or halogen, a represents an integer of 1 to 3, b represents an integer of 0 to 2, and a sum of a and b is 1 to 3.

R¹ in General Formula [1] may contain not only a hydrogen element, a carbon element, a nitrogen element, an oxygen element, and a fluorine element but also a silicon element, a sulfur element, a halogen element (other than fluorine).

In addition, R¹ in General Formula [1] may contain an unsaturated bond, an aromatic ring, or a cyclic structure.

Examples of R¹'s in General Formula [1] each independently include at least one group selected from CₑH_{2e + 1} (e = 1 to 18) and C_{f}F_{2f + 1}CH₂CH₂ (f = 1 to 8). Among these, a silicon compound having a trialkylsilyl group is particularly preferable.

It is noted that in a case where R¹ in General Formula [1] described above includes a silicon element, General Formula [1] may have a structure of General Formula [1-1] shown below.

R¹ₘX₃₋ₘ₋ₙ(H)ₙSi-(CH₂)ₚ-Si(H)ₙX₃₋ₘ₋ₙR¹ₘ [1-1]

It is noted that in General Formula [1-1], R¹'s and X are the same as in General Formula [1] (however, a silicon element is not included in R¹'s), m is an integer of 1 or 2, n is an integer of 0 or 1, a sum of m and n is 1 or 2, p is an integer of 1 to 18, and a methylene chain represented by -(CH₂)ₚ- may be substituted with halogen.

In X in General Formula [1], the monovalent organic group in which the element bonded to the Si element is nitrogen, oxygen, or carbon may include not only hydrogen, carbon, nitrogen, and oxygen elements but also a silicon element, a sulfur element, a halogen element.

Examples of the above-described monovalent organic group in which the element bonded to the Si element is nitrogen include an isocyanate group, an amino group, a dialkylamino group, an isothiocyanate group, an azido group, an acetamide group, - NHC(=O)CF₃, -N(CH₃)C(=O)CH₃, -N(CH₃)C(=O)CF₃, -N=C(CH₃)OSi(CH₃)₃, - N=C(CF₃)OSi(CH₃)₃, -NHC(=O)-OSi(CH₃)₃, -NHC(=O)-NH-Si(CH₃)₃, an imidazole ring, a triazole ring, a tetrazole ring, an oxazolidinone ring, a morpholine ring, -NH-C(=O)-Si(CH₃)₃, - N(S(=O)₂R⁴)₂ (here, R⁴'s each independently represent a group selected from the group consisting of a monovalent hydrocarbon group having 1 to 8 carbon atoms, in which a part or all of hydrogen elements may be substituted with a fluorine element, and a fluorine element), a substituent having a structure of General Formula [1-2] 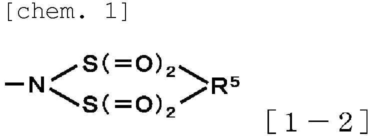 (In General Formula [1-2], R⁵'s each independently is a divalent hydrocarbon group having 1 to 8 carbon atoms in which part or all of the hydrogen elements may be substituted with fluorine elements), -N=C(NR⁶₂)₂, -N=C(NR⁶₂)R⁶ (here, R⁶'s each independently is selected from a hydrogen group, a -C≡N group, a -NO₂ group, and a hydrocarbon group in which part or all of hydrogen elements may be substituted with fluorine elements, and the hydrocarbon group may have an oxygen atom and/or a nitrogen atom), -N(R^{a1})(R^{a2}) (Here, R^{a1} represents a hydrogen atom, or a saturated or unsaturated alkyl group, and R^{a2} represents a saturated or unsaturated alkyl group, a saturated or unsaturated cycloalkyl group, or a saturated or unsaturated heterocycloalkyl group. R^{a1} and R^{a2} may be bonded to each other to form a saturated or unsaturated heterocycloalkyl group having a nitrogen atom), -N(R ^{a3})-Si(R^{a4})(R^{a5})(R^{a6}) (here, R^{a3} represents a hydrogen atom, a hydrocarbon group having 1 to 4 carbon atoms, a trimethylsilyl group, or a dimethylsilyl group, R^{a4}, R^{a5}, and R^{a6} each independently represent a hydrogen atom or an organic group, the total number of carbon atoms contained in R^{a4}, R^{a5}, and R^{a6} is equal to or more than 1), -N(R^{a7})-C(=O)R^{a8} (here, R^{a7} represents a hydrogen atom, a methyl group, a trimethylsilyl group, or a dimethylsilyl group, and R^{a8} represents a hydrogen atom, a saturated or unsaturated alkyl group, or a fluorine-containing alkyl group, or a trialkylsilylamino group), and the like.

Examples of the silylating agent, in which X in General Formula [1] is a monovalent organic group having nitrogen as an element bonded to the Si element, include amino silanes such as CH₃Si(NH₂)₃, C₂H₅Si(NH₂)₃, C₃H₇Si(NH₂)₃, C₄H₉Si(NH₂)₃, C₅H₁₁Si(NH₂)₃, C₆H₁₃Si(NH₂)₃, C₇H₁₅Si(NH₂)₃, C₈H₁₇Si(NH₂)₃, C₉H₁₉Si(NH₂)₃, C₁₀H₂₁Si(NH₂)₃, C₁₁H₂₃Si(NH₂)₃, C₁₂H₂₅Si(NH₂)₃, C₁₃H₂₇Si(NH₂)₃, C₁₄H₂₉Si(NH₂)₃, C₁₅H₃₁Si(NH₂)₃, C₁₆H₃₃Si(NH₂)₃, C₁₇H₃₅Si(NH₂)₃, C₁₈H₃₇Si(NH₂)₃, (CH₃)₂Si(NH₂)₂, C₂H₅Si(CH₃)(NH₂)₂, (C₂H₅)₂Si(NH₂)₂, C₃H₇Si(CH₃)(NH₂)₂, (C₃H₇)₂Si(NH₂)₂, C₄H₉Si(CH₃)(NH₂)₂, (C₄H₉)₂Si(NH₂)₂, C₅H₁₁Si(CH₃)(NH₂)₂, C₆H₁₃Si(CH₃)(NH₂)₂, C₇H₁₅Si(CH₃)(NH₂)₂, C₈H₁₇Si(CH₃)(NH₂)₂, C₉H₁₉Si(CH₃)(NH₂)₂, C₁₀H₂₁Si(CH₃)(NH₂)₂, C₁₁H₂₃Si(CH₃)(NH₂)₂, C₁₂H₂₅Si(CH₃)(NH₂)₂, C₁₃H₂₇Si(CH₃)(NH₂)₂, C₁₄H₂₉Si(CH₃)(NH₂)₂, C₁₅H₃₁Si(CH₃)(NH₂)₂, C₁₆H₃₃Si(CH₃)(NH₂)₂, C₁₇H₃₅Si(CH₃)(NH₂)₂, C₁₈H₃₇Si(CH₃)(NH₂)₂, (CH₃)₃SiNH₂, C₂H₅Si(CH₃)₂NH₂, (C₂H₅)₂Si(CH₃)NH₂, (C₂H₅)₃SiNH₂, C₃H₇Si(CH₃)₂NH₂, (C₃H₇)₂Si(CH₃)NH₂, (C₃H₇)₃SiNH₂, C₄H₉Si(CH₃)₂NH₂, (C₄H₉)₃SiNH₂, C₅H₁₁Si(CH₃)₂NH₂, C₆H₁₃Si(CH₃)₂NH₂, C₇H₁₅Si(CH₃)₂NH₂, C₈H₁₇Si(CH₃)₂NH₂, C₉H₁₉Si(CH₃)₂NH₂, C₁₀H₂₁Si(CH₃)₂NH₂, C₁₁H₂₃Si(CH₃)₂NH₂, C₁₂H₂₅Si(CH₃)₂NH₂, C₁₃H₂₇Si(CH₃)₂NH₂, C₁₄H₂₉Si(CH₃)₂NH₂, C₁₅H₃₁Si(CH₃)₂NH₂, C₁₆H₃₃Si(CH₃)₂NH₂, C₁₇H₃₅Si(CH₃)₂NH₂, C₁₈H₃₇Si(CH₃)₂NH₂, (CH₃)₂Si(H)NH₂, CH₃Si(H)₂NH₂, (C₂H₅)₂Si(H)NH₂, C₂H₅Si(H)₂NH₂, C₂H₅Si(CH₃)(H)NH₂, (C₃H₇)₂Si(H)NH₂, C₃H₇Si(H)₂NH₂, CF₃CH₂CH₂Si(NH₂)₃, C₂F₅CH₂CH₂Si(NH₂)₃, C₃F₇CH₂CH₂Si(NH₂)₃, C₄F₉CH₂CH₂Si(NH₂)₃, C₅F₁₁CH₂CH₂Si(NH₂)₃, C₆F₁₃CH₂CH₂Si(NH₂)₃, C₇F₁₅CH₂CH₂Si(NH₂)₃, C₈F₁₇CH₂CH₂Si(NH₂)₃, CF₃CH₂CH₂Si(CH₃)(NH₂)₂, C₂F₅CH₂CH₂Si(CH₃)(NH₂)₂, C₃F₇CH₂CH₂Si(CH₃)(NH₂)₂, C₄F₉CH₂CH₂Si(CH₃)(NH₂)₂, C₅F₁₁CH₂CH₂Si(CH₃)(NH₂)₂, C₆F₁₃CH₂CH₂Si(CH₃)(NH₂)₂, C₇F₁₃CH₂CH₂Si(CH₃)(NH₂)₂, C₈F₁₇CH₂CH₂Si(CH₃)(NH₂)₂, CF₃CH₂CH₂Si(CH₃)₂NH₂, C₂F₃CH₂CH₂Si(CH₃)₂NH₂, C₃F₇CH₂CH₂Si(CH₃)₂NH₂, C₄F₉CH₂CH₂Si(CH₃)₂NH₂, C₅F₁₁CH₂CH₂Si(CH₃)₂NH₂, C₆F₁₃CH₂CH₂Si(CH₃)₂NH₂, C₇F₁₃CH₂CH₂Si(CH₃)₂NH₂, C₈F₁₇CH₂CH₂Si(CH₃)₂NH₂, CF₃CH₂CH₂Si(CH₃)(H)NH₂, aminodimethylvinylsilane, aminodimethylphenylethylsilane, aminodimethylphenylsilane, aminomethyldiphenylsilane, and aminodimethyl-t-butylsilane.

In addition, examples thereof include those obtained by replacing the amino group (-NH₂ group) in the amino silane with the following groups:
-N=C=O, a dialkylamino group (-N(CH₃)₂, -N(C₂H₅)₂, and the like), a t-butylamino group, an allylamino group, -N=C=S, -N₃, - NHC(=O)CH₃, -NHC(=O)CF₃, -N(CH₃)C(=O)CH₃, -N(CH₃)C(=O)CF₃, - N=C(CH₃)OSi(CH₃)₃, -N=C(CF₃)OSi(CH₃)₃, -NHC(=O)-OSi(CH₃)₃, - NHC(=O)-NH-Si(CH₃)₃ (for example, N,N'-bis(trimethylsilyl)urea and the like), an imidazole ring (for example, N-trimethylsilylimidazole and the like), a triazole ring (for example, N-trimethylsilyltriazole), a tetrazole ring, an oxazolidinone ring, a morpholine ring, -NH-C(=O)-Si(CH₃)₃, - N(S(=O)₂R⁴)₂ (here, R⁴'s each independently represent a group selected from the group consisting of a monovalent hydrocarbon group having 1 to 8 carbon atoms, in which a part or all of hydrogen elements may be substituted with a fluorine element, and a fluorine element; for example, N-(trimethylsilyl)bis(trifluoromethanesulfonyl)imide and the like), a substituent having a structure of General Formula [1-2] 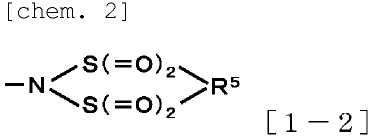 (In General Formula [1-2], R⁵'s each independently represent a divalent hydrocarbon group having 1 to 8 carbon atoms, in which a part of or all of hydrogen elements may be substituted with a fluorine element. For example, N-(trimethylsilyl) N,N-difluoromethane-1,3-bis (sulfonyl) imide and the like), - N=C(NR⁶₂)₂, -N=C(NR⁶₂)R⁶ (Here, R⁶ each independently selected from a hydrogen group, a -C≡N group, a -NO₂ group, and a hydrocarbon group in which part or all of hydrogen elements may be substituted with fluorine elements, and the hydrocarbon group may have an oxygen atom and/or a nitrogen atom. For example, 2-trimethylsilyl-1,1,3,3-tetramethylguanidine, and the like), - N(R^{a1})R^{a2} (here, R^{a1} represents a hydrogen atom or a saturated or unsaturated alkyl group, R^{a2} represents a saturated or unsaturated alkyl group, a saturated or unsaturated cycloalkyl group, or a saturated or unsaturated heterocycloalkyl group. R^{a1} and R^{a2} may be bonded to form a saturated or unsaturated heterocycloalkyl group having a nitrogen atom), -N(R^{a3})-Si(R^{a4})(R^{a5}) (R^{a6}) (Here, R^{a3} represents a hydrogen atom, a hydrocarbon group having 1 to 4 carbon atoms, a trimethylsilyl group, or a dimethylsilyl group, and R^{a4}, R^{a5}, and R^{a6} each independently represent a hydrogen atom or an organic group, and the total number of carbon atoms contained in R^{a4}, R^{a5}, and R^{a6} is one or more. For example, hexamethyldisilazane, N-methylhexamethyldisilazane, 1,1,3,3-tetramethyldisilazane, 1,3-dimethyldisilazane, 1,3-di-N-octyltetramethyldisilazane, 1,3-divinyltetramethyldisilazane, heptamethyldisilazane, N-allyl-N,N-bis(trimethylsilyl)amine, 1,3-diphenyltetramethyldisilazane, 1,1,3,3-tetraphenyl-1,3-dimethyldisilazane, nonamethyltrisilazane, pentamethylethyldisilazane, pentamethylvinyldisilazane, pentamethylpropyldisilazane, pentamethylethyldisilazane, pentamethyl-t-butyldisilazane, pentamethylphenyldisilazane, trimethyltriethyldisilazane, and the like), -N(R^{a7})-C(=O)R^{a8} (Here, R^{a7} represents a hydrogen atom, a methyl group, a trimethylsilyl group, or a dimethylsilyl group, and R^{a8} represents a hydrogen atom, a saturated or unsaturated alkyl group, a fluorine-containing alkyl group, or a trialkylsilylamino group. For example, N-trimethylsilylacetamide, N-trimethylsilyltrifluoroacetamide, N-methyl-N-trimethylsilylacetamide, N-methyl-N-trimethylsilyltrifluoroacetamide, bis(trimethylsilyl) acetamide, bis(trimethylsilyl) trifluoroacetamide, and the like).

Examples of the silylating agent in which X in General Formula [1] is a monovalent organic group in which the element bonded to the Si element is oxygen include those obtained by substituting an amino group (-NH₂ group) of the amino silane with -O-C(=A)R^{a9} (Here, A represents O, CHR^{a10}, CHOR^{a10}, CR^{a10}R^{a10}, or NR^{a11}, where R^{a9} and R^{a10} each independently are a hydrogen atom, a saturated or unsaturated alkyl group, a saturated or unsaturated cycloalkyl group, a fluorine-containing alkyl group, a chlorine-containing alkyl group, a trialkylsilyl group, a trialkylsiloxy group, an alkoxy group, a phenyl group, a phenyl ethyl group, or an acetyl group, and R^{a11} represents a hydrogen atom, an alkyl group, or a trialkylsilyl group. For example, trimethylsilyl acetate, dimethylsilyl acetate, monomethylsilyl acetate, trimethylsilyl trifluoroacetate, dimethylsilyl trifluoroacetate, monomethylsilyl trifluoroacetate, trimethylsilyl trichloroacetate, trimethylsilyl propionate, trimethylsilyl butyrate, and the like), -O-C(R^{a12})=N(R^{a13}) (here, R^{a12} represents a hydrogen atom, a saturated or unsaturated alkyl group, a fluorine-containing alkyl group, or a trialkylsilylamino group, and R^{a13} represents a hydrogen atom, an alkyl group, and a trialkylsilyl group), -O-C(R^{a14})=CH-C(=O) R^{a15} (Here, R^{a14} and R^{a15} each independent represents a hydrogen atom or an organic group. For example, trimethylsilyloxy-3-pentene-2-on, 2-trimethylsiloxypenta-2-en-4-on, and the like), -OR^{a16} (here, R^{a16} represents a saturated or unsaturated alkyl group, a saturated or unsaturated cycloalkyl group, or a fluorine-containing alkyl group. Examples of the silylating agent having the -OR^{a16} include alkyl methoxysilanes such as CH₃Si(OCH₃)₃, C₂H₅Si(OCH₃)₃, C₃H₇Si(OCH₃)₃, C₄H₉Si(OCH₃)₃, C₅H₁₁Si(OCH₃)₃, C₆H₁₃Si(OCH₃)₃, C₇H₁₅Si(OCH₃)₃, C₈H₁₇Si(OCH₃)₃, C₉H₁₉Si(OCH₃)₃, C₁₀H₂₁Si(OCH₃)₃, C₁₁H₂₃Si(OCH₃)₃, C₁₂H₂₅Si(OCH₃)₃, C₁₃H₂₇Si(OCH₃)₃, C₁₄H₂₉Si(OCH₃)₃, C₁₅H₃₁Si(OCH₃)₃, C₁₆H₃₃Si(OCH₃)₃, C₁₇H₃₅Si(OCH₃)₃, C₁₈H₃₇Si(OCH₃)₃, (CH₃)₂Si(OCH₃)₂, C₂H₅Si(CH₃)(OCH₃)₂, (C₂H₅)₂Si(OCH₃)₂, C₃H₇Si(CH₃)(OCH₃)₂, (C₃H₇)₂Si(OCH₃)₂, C₄H₉Si(CH₃)(OCH₃)₂, (C₄H₉)₂Si(OCH₃)₂, C₅H₁₁Si(CH₃)(OCH₃)₂, C₆H₁₃Si(CH₃)(OCH₃)₂, C₇H₁₅Si(CH₃)(OCH₃)₂, C₈H₁₇Si(CH₃)(OCH₃)₂, C₉H₁₉Si(CH₃)(OCH₃)₂, C₁₀H₂₁Si(CH₃)(OCH₃)₂, C₁₁H₂₃Si(CH₃)(OCH₃)₂, C₁₂H₂₅Si(CH₃)(OCH₃)₂, C₁₃H₂₇Si(CH₃)(OCH₃)₂, C₁₄H₂₉Si(CH₃)(OCH₃)₂, C₁₅H₃₁Si(CH₃)(OCH₃)₂, C₁₆H₃₃Si(CH₃)(OCH₃)₂, C₁₇H₃₅Si(CH₃)(OCH₃)₂, C₁₈H₃₇Si(CH₃)(OCH₃)₂, (CH₃)₃SiOCH₃, C₂H₅Si(CH₃)₂OCH₃, (C₂H₅)₂Si(CH₃)OCH₃, (C₂H₅)₃SiOCH₃, C₃H₇Si(CH₃)₂OCH₃, (C₃H₇)₂Si(CH₃)OCH₃, (C₃H₇)₃SiOCH₃, C₄H₉Si(CH₃)₂OCH₃, (C₄H₉)₃SiOCH₃, C₅H₁₁Si(CH₃)₂OCH₃, C₆H₁₃Si(CH₃)₂OCH₃, C₇H₁₅Si(CH₃)₂OCH₃, C₈H₁₇Si(CH₃)₂OCH₃, C₉H₁₉Si(CH₃)₂OCH₃, C₁₀H₂₁Si(CH₃)₂OCH₃, C₁₁H₂₃Si(CH₃)₂OCH₃, C₁₂H₂₅Si(CH₃)₂OCH₃, C₁₃H₂₇Si(CH₃)₂OCH₃, C₁₄H₂₉Si(CH₃)₂OCH₃, C₁₅H₃₁Si(CH₃)₂OCH₃, C₁₆H₃₃Si(CH₃)₂OCH₃, C₁₇H₃₅Si(CH₃)₂OCH₃, C₁₈H₃₇Si(CH₃)₂OCH₃, (CH₃)₂Si(H)OCH₃, CH₃Si(H)₂OCH₃, (C₂H₅)₂Si(H)OCH₃, C₂H₅Si(H)₂OCH₃, C₂H₅Si(CH₃)(H)OCH₃, and (C₃H₇)₂Si(H)OCH₃; fluoroalkyl methoxysilanes such as CF₃CH₂CH₂Si(OCH₃)₃, C₂F₅CH₂CH₂Si(OCH₃)₃, C₃F₇CH₂CH₂Si(OCH₃)₃, C₄F₉CH₂CH₂Si(OCH₃)₃, C₅F₁₁CH₂CH₂Si(OCH₃)₃, C₆F₁₃CH₂CH₂Si(OCH₃)₃, C₇F₁₅CH₂CH₂Si(OCH₃)₃, C₈F₁₇CH₂CH₂Si(OCH₃)₃, CF₃CH₂CH₂Si(CH₃)(OCH₃)₂, C₂F₃CH₂CH₂Si(CH₃)(OCH₃)₂, C₃F₇CH₂CH₂Si(CH₃)(OCH₃)₂, C₄F₉CH₂CH₂Si(CH₃)(OCH₃)₂, C₅F₁₁CH₂CH₂Si(CH₃)(OCH₃)₂, C₆F₁₃CH₂CH₂Si(CH₃)(OCH₃)₂, C₇F₁₅CH₂CH₂Si (CH₃)(OCH₃)₂, C₈F₁₇CH₂CH₂Si(CH₃)(OCH₃)₂, CF₃CH₂CH₂Si(CH₃)₂OCH₃, C₂F₅CH₂CH₂Si(CH₃)₂OCH₃, C₃F₇CH₂CH₂Si(CH₃)₂OCH₃, C₄F₉CH₂CH₂Si(CH₃)₂OCH₃, C₅F₁₁CH₂CH₂Si(CH₃)₂OCH₃, C₆F₁₃CH₂CH₂Si(CH₃)₂OCH₃, C₇F₁₅CH₂CH₂Si(CH₃)₂OCH₃, C₈F₁₇CH₂CH₂Si(CH₃)₂OCH₃, and CF₃CH₂CH₂Si(CH₃)(H)OCH₃; or a compound or the like obtained by replacing the methyl group moiety of the methoxy group of the methoxysilane with a monovalent hydrocarbon group having 2 to 18 carbon atoms in which a part or all of hydrogen elements may be substituted with a fluorine element), and
-O-S(=O)₂-R^{a17} (here, R^{a17} represents an alkyl group having 1 to 6 carbon atoms, a perfluoroalkyl group, a phenyl group, a tolyl group, or a -O-Si(CH₃)₃ group. For example, trimethylsilylsulfonate, trimethylsilylbenzenesulfonate, trimethylsilyltoluenesulfonate, trimethylsilyltrifluoromethanesulfonate, trimethylsilylperfluorobutanesulfonate, bistrimethylsilylsulfate, and the like) -O-P(-O-Si(CH₃)₃)₂ (for example, tristrimethylsilylphosphite).

In addition, examples of the silylating agent, in which X in General Formula [1] is a monovalent organic group having oxygen as an element bonded to the Si element, also include siloxane compounds such as hexamethyldisiloxane, 1,3-diphenyl-1,3-dimethyldisiloxane, 1,1,3,3-tetramethyldisiloxane, 1,1,1-triethyl-3,3-dimethyldisiloxane, 1,1,3,3-tetra-n-octyldimethyldisiloxane, bis(nonafluorohexyl)tetramethyldisiloxane, 1,3-bis(trifluoropropyl)tetramethyldisiloxane, 1,3-di-n-butyltetramethyldisiloxane, 1,3-di-n-octyltetramethyldisiloxane, 1,3-diethyltetramethyldisiloxane, 1,3-diphenyltetramethyldisiloxane, hexa-n-butyl disiloxane, hexaethyldisiloxane, hexavinyl disiloxane, 1,1,3,3-tetraisopropyldisiloxane, vinylpentamethyldisiloxane, 1,3-bis(3-chloroisobutyl)tetramethyldisiloxane, hexaphenyldisiloxane, 1,1,1-triethyl-3,3,3-trimethyldisiloxane, 1,3-bis(chloromethyl)tetramethyldisiloxane, 1,1,3,3-tetraphenyldimethyldisiloxane, pentamethyldisiloxane, 1,3-bis(3-chloropropyl)tetramethyldisiloxane, 1,3-dichloro-1,3-diphenyl-1,3-dimethyldisiloxane, n-butyl-1,1,3,3-tetramethyldisiloxane, 1,3-di-t-butyl disiloxane, vinyl-1,1,3,3,-tetramethyldisiloxane, 1,1,1-trimethyl-3,3,3-triphenyldisiloxane, 3,3-diphenyltetramethyltrisiloxane, 3-phenylheptamethyltrisiloxane, hexamethylcyclotrisiloxane, n-propylheptamethyltrisiloxane, 3-ethylheptamethyltrisiloxane, 3-(3,3,3-trifluoropropyl)heptamethyltrisiloxane, 1,1,3,5,5-pentaphenyl-1,3,5-trimethyltrisiloxane, octamethyltrisiloxane, 1,1,5,5-tetraphenyl-1,3,3,5-tetramethyltrisiloxane, hexaphenylcyclotrisiloxane, 1,1,1,5,5,5-hexamethyltrisiloxane, 3-phenyl-1,1,3,5,5-pentamethyltrisiloxane, 1,3,5-trivinyl-1,1,3,5,5-pentamethyltrisiloxane, 1,3,5-trivinyl-1,3,5-trimethylcyclotrisiloxane, 3-octylheptamethyltrisiloxane, 1,3,5-triphenyltrimethylcyclotrisiloxane, 1,1,1,3,3,5,5-heptamethyltrisiloxane, 1,1,3,3,5,5-hexamethyltrisiloxane, 1,1,1,5,5,5-hexaethyl-3-methyltrisiloxane, flufrilloxytrisiloxane, tetrakis(dimethylsiloxy)silane, 1,1,3,3,5,5,7,7-octamethyltetrasiloxane, diphenylsiloxanedimethylsiloxane copolymer, 1,3-diphenyl-1,3-dimethyldisiloxane, octamethylcyclotetrasiloxane, 1,3-bis(trimethylsiloxy)-1,3-dimethyldisiloxane, tetra-n-propyltetramethylcyclotetrasiloxane, octaethylcyclotetrasiloxane, decamethyltetrasiloxane, dodecamethylcyclohexasiloxane, dodecamethylpentasiloxane, tetradecamethylhexasiloxane, hexaphenylcyclotrisiloxane, polydimethylsiloxane, polyoctadecylmethylsiloxane, decamethylcyclopentasiloxane, poly(3,3,3-trifluoropropylmethylsiloxane), a polydimethylsiloxane terminated with trimethylsiloxy, and 1,1,3,3,5,5,7,7,9,9-decamethylpentasiloxane.

Examples of the silylating agent, in which X in General Formula [1] is a monovalent organic group having carbon as an element bonded to the Si element, include those obtained by substituting an amino group (-NH₂ group) of the amino silane with -C(S(=O)₂R⁷)₃ (here, R⁷'s are each independently a group selected from the group consisting of a monovalent hydrocarbon group having 1 to 8 carbon atoms in which part or all of hydrogen elements may be substituted with fluorine elements, and a fluorine element. For example, (trimethylsilyl) tris(trifluoromethanesulfonyl) methide, and the like).

In addition, examples of the silylating agent, in which X in General Formula [1] is a monovalent organic group having a halogen as an element bonded to the Si element, include those obtained by replacing the amino group (-NH₂ group) in the above-described amino silane with a chloro group, a bromo group, or an iodo group (for example, chlorotrimethylsilane, bromotrimethylsilane, and the like).

The above-described silylating agent may include a cyclic silazane compound.

Examples of the above-described cyclic silazane compound include cyclic disilazane compounds such as 2,2,5,5-tetramethyl-2,5-disila-1-azacyclopentane and 2,2,6,6-tetramethyl-2,6-disila-1-azacyclohexane; cyclic trisilazane compounds such as 2,2,4,4,6,6-hexamethylcyclotrisilazane and 2,4,6-trimethyl-2,4,6-trivinylcyclotrisilazane; and cyclic tetrasilazane compounds such as 2,2,4,4,6,6,8,8-octamethylcyclotetrasilazane.

In a case where the above-described silylating agent is supplied in a form of a gas such as a gas, the silylating agent may be supplied as a mixed gas that is used together with an inert gas at the same time. Examples of the inert gas include N₂, Ar, He, Ne, and CF₄. N₂, Ar, or He is preferable.

The silylation composition refers to a composition in which two or more kinds of the above-described silylating agents are combined, or a composition containing a compound other than the above-described mixed gas or the silylating agent. The above-described silylation composition may contain in addition to the above-described silylating agent, a catalytic compound that promotes the silylation reaction by the silylating agent. As the catalytic compound, it is preferable to use one or more kinds selected from the group consisting of a compound A described later, an acid imidized product, a nitrogen-containing compound, a nitrogen-containing heterocyclic compound not containing a silicon atom, and a silylated heterocyclic compound.

Here, the catalytic compound is a compound that can promote the above-described reaction between each of the surfaces and the silylating agent or can enhance the water-repellency performance of the water repellent film to be formed, and the catalytic compound itself or a modified product thereof may form a part of the water repellent film.

The concentration of the catalytic compound may be, for example, 0.005% by mass or more and 20% by mass or less, or 0.05% by mass or more and 15% by mass or less with respect to 100% by mass of the above-described silylation composition.

Specific examples of the above-described compound A include trimethylsilyl trifluoroacetate, trimethylsilyl trifluoromethanesulfonate, dimethylsilyl trifluoroacetate, dimethylsilyl trifluoromethanesulfonate, butyldimethylsilyl trifluoroacetate, butyldimethylsilyl trifluoromethanesulfonate, hexyldimethylsilyl trifluoroacetate, hexyldimethylsilyl trifluoromethanesulfonate, octyldimethylsilyl trifluoroacetate, octyldimethylsilyl trifluoromethanesulfonate, decyldimethylsilyl trifluoroacetate, and decyldimethylsilyl trifluoromethanesulfonate, and one or more kinds selected from these compounds can be included. These may be used alone, or two or more thereof may be used in combination.

It is noted that although the above-described compound A may correspond to the above-described silylating agent, the compound A is intended to mean that, in a case of being used as a catalytic compound, the compound A to be used and the above-described silylating agent are used in combination.

The above-described compound A may be a compound obtained by reacting a silicon compound represented by General Formula [2] with one or more acetic acids or sulfonic acids selected from the group consisting of trifluoroacetic acid, trifluoroacetic acid anhydride, trifluoromethanesulfonic acid, and trifluoromethanesulfonic acid anhydride.

A surplus silicon compound represented by General Formula [2], which remains without being consumed in this reaction, can be used as the above-described silylating agent together with the compound A obtained in the reaction. The silicon compound represented by General Formula [2] may be reacted with the above-described acetic acid or sulfonic acid at a molar ratio of, for example, 0.2 to 100,000 times by mole, preferably 0.5 to 50000 times by mole and more preferably 1 to 10,000 times by mole.

R²_{c}(H)_{d}Si-X [2]

In General Formula [2], examples of R²_{c}(H)_{d}Si- include (CH₃)₃Si-, (CH₃)₂(H)Si-, (C₄H₉)(CH₃)₂Si-, (C₆H₁₃)(CH₃)₂Si-, (C₈H₁₇)(CH₃)₂Si-, and (C₁₀H₂₁)(CH₃)₂Si-. In addition, X is the same as in General Formula [1] described above.

In addition, the above-described compound A may be at least one kind selected from the group consisting of a sulfonic acid represented by General Formula [3], an anhydride of the sulfonic acid, a salt of the sulfonic acid, and a sulfonic acid derivative represented by General Formula [4].

R⁸-S(=O)₂OH [3]

[In General Formula [3], R⁸ represents a group selected from the group consisting of a monovalent hydrocarbon group having 1 to 8 carbon atoms, in which a part or all of hydrogen elements may be substituted with a fluorine element, and a hydroxyl group.]

   R^{8'}-S(=O)₂O-Si(H)₃₋ᵣ(R⁹)ᵣ [4]
[In General Formula [4], R^{8'} represents a monovalent hydrocarbon group having 1 to 8 carbon atoms, in which a part or all of hydrogen elements may be substituted with a fluorine element, R⁹'s each independently represent at least one group selected from monovalent hydrocarbon groups having 1 to 18 carbon atoms, in which a part or all of hydrogen elements may be substituted with a fluorine element, and r represents an integer of 1 to 3.]

In addition, the above-described compound A may be at least one kind selected from the group consisting of a sulfonic acid ester represented by General Formula [5], a sulfonimide represented by each of General Formulae [6] and [7], sulfonimide derivatives represented by General Formulae [8] and [9], a sulfone methide represented by General Formula [10], and a sulfone methide derivative represented by General Formula [11].

R¹⁰-S(=O)₂OR¹¹ [5]

[In General Formula [5], R¹⁰ represents a group selected from the group consisting of a monovalent hydrocarbon group having 1 to 8 carbon atoms, in which a part or all of hydrogen elements may be substituted with a fluorine element, and a fluorine element, and R¹¹ represents a monovalent alkyl group having 1 to 18 carbon atoms.]

   (R¹²-S(=O)₂)₂NH [6]
[In General Formula [6], R¹²'s each independently represent a group selected from the group consisting of a monovalent hydrocarbon group having 1 to 8 carbon atoms, in which a part or all of hydrogen elements may be substituted with a fluorine element, and a fluorine element.] 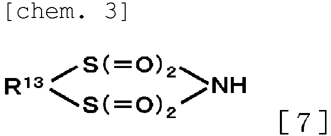
[In General Formula [7], R¹³ represents a divalent hydrocarbon group having 1 to 8 carbon atoms, in which a part or all of hydrogen elements may be substituted with a fluorine element.]

   ((R¹⁴-S(=O)₂)₂N)ₛSi(H)ₜ(R¹⁵)₄₋ₛ₋ₜ [8]
[In General Formula [8], R¹⁴'s each independently represent a group selected from the group consisting of a monovalent hydrocarbon group having 1 to 8 carbon atoms, in which a part or all of hydrogen elements may be substituted with a fluorine element, and a fluorine element, R¹⁵'s each independently represent a monovalent hydrocarbon group having 1 to 18 carbon atoms, in which a part or all of hydrogen elements may be substituted with a fluorine element, s represents an integer of 1 to 3, t represents an integer of 0 to 2, and a sum of s and t is 3 or less.] 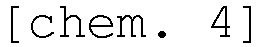 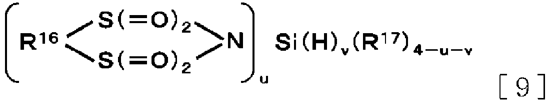
[In General Formula [9], R¹⁶'s each independently represent a divalent hydrocarbon group having 1 to 8 carbon atoms, in which a part or all of hydrogen elements may be substituted with a fluorine element, R¹⁷'s each independently represent a monovalent hydrocarbon group having 1 to 18 carbon atoms, in which a part or all of hydrogen elements may be substituted with a fluorine element, u represents an integer of 1 to 3, v represents an integer of 0 to 2, and a sum of u and v is 3 or less.]

   (R¹⁸-S(=O)₂)₃CH [10]
[In General Formula [10], R¹⁸'s each independently represent a group selected from the group consisting of a monovalent hydrocarbon group having 1 to 8 carbon atoms, in which a part or all of hydrogen elements may be substituted with a fluorine element, and a fluorine element.]

   ((R¹⁹-S(=O)₂)₃C)_{w}Si(H)ₓ(R²⁰)_{4-w-x} [11]
[In General Formula [11], R¹⁹'s each independently represent a group selected from the group consisting of a monovalent hydrocarbon group having 1 to 8 carbon atoms, in which a part or all of hydrogen elements may be substituted with a fluorine element, and a fluorine element, R²⁰'s each independently represent a monovalent hydrocarbon group having 1 to 18 carbon atoms, in which a part or all of hydrogen elements may be substituted with a fluorine element, w represents an integer of 1 to 3, x represents an integer of 0 to 2, and a sum of w and x is 3 or less.]

In addition, examples of the above-described acid imidized product that can be used as a catalytic compound include compounds having a chemical structure in which an acid such as a carboxylic acid or a phosphoric acid is imidized.

In addition, examples of the above-described nitrogen-containing compound that can be used as a catalytic compound include at least one kind of compounds represented by General Formulae [12] and [13].

R²¹-N=C(NR²²₂)₂ [12]

R²¹-N=C(NR²²₂)R²² [13]

[In General Formulae [12] and [13], R²¹ is selected from a hydrogen group, a -C=N group, a -NO₂ group, an alkylsilyl group, and a hydrocarbon group in which a part or all of hydrogen elements may be substituted with a fluorine element, where although the hydrocarbon group may have an oxygen atom and/or a nitrogen atom, the hydrocarbon group has an acyclic structure in a case of containing a nitrogen atom. R²² each independently is selected from a hydrogen group, a -C=N group, a -NO₂ group, and a hydrocarbon group in which part or all of hydrogen elements may be substituted with fluorine elements, the hydrocarbon group may have an oxygen atom and/or a nitrogen atom, and in a case of including a nitrogen atom, R²² has an acyclic structure.]

In addition, examples of the above-described nitrogen-containing compound include compounds having a guanidine skeleton, such as guanidine, 1,1,3,3-tetramethylguanidine, 2-tert-butyl-1,1,3,3-tetramethylguanidine, 1,3-diphenylguanidine, 1,2,3-triphenylguanidine, N, N'-diphenylformamidine, and 2,2,3,3,3-pentafluoropropylamidine.

In addition, examples of the nitrogen-containing heterocyclic compound not containing a silicon atom and the silylated heterocyclic compound, which can be used as a catalytic compound, include at least one kind of compounds represented by General Formulae [14] and [15]. 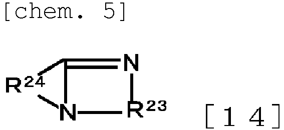
[In General Formula [14], R²³ and R²⁴ each independently represent a divalent organic group consisting of a carbon element and/or a nitrogen element, and a hydrogen element, the total number of carbon atoms and nitrogen atoms is 1 to 9, and in a case of 2 or more, a carbon element which does not form a ring may be present.] 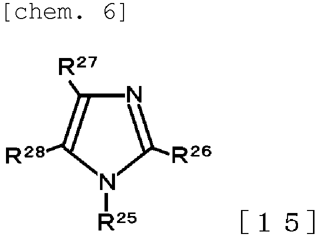
[In General Formula [15], R²⁵ represents an alkyl group having 1 to 6 carbon atoms, in which a part or all of hydrogen elements may be substituted with a fluorine element, a trialkylsilyl group having an alkyl group having 1 to 8 carbon atoms, in which a part or all of hydrogen elements may be substituted with a fluorine element, an alkenyl group having 2 to 6 carbon atoms, in which a part or all of hydrogen elements may be substituted with a fluorine element, an alkoxy group having 1 to 6 carbon atoms, in which a part or all of hydrogen elements may be substituted with a fluorine element, an amino group, an alkylamino group having an alkyl group having 1 to 6 carbon atoms, in which a part or all of hydrogen elements may be substituted with a fluorine element, a dialkylamino group having an alkyl group having 1 to 6 carbon atoms, in which a part or all of hydrogen elements may be substituted with a fluorine element, an aminoalkyl group having 1 to 6 carbon atoms, in which a part or all of hydrogen elements may be substituted with a fluorine element, a nitro group, a cyano group, a phenyl group, a benzyl group, or a halogen group, and R²⁶, R²⁷, and R²⁸ each independently represent an alkyl group having 1 to 6 carbon atoms, in which a part or all of hydrogen elements may be substituted with a fluorine element, or a hydrogen group.]

In addition, the above-described nitrogen-containing heterocyclic compound not containing a silicon atom may include, in the ring, a heteroatom other than the nitrogen atom, such as an oxygen atom and a sulfur atom, may have aromaticity, or may be a compound in which two or more of a plurality of rings are single-bonded or are bonded to each other through a polyvalent linking group of di- or higher valent. In addition, the above-described nitrogen-containing heterocyclic compound not containing a silicon atom may have a substituent.

Examples of the above-described nitrogen-containing heterocyclic compound not containing a silicon atom include pyridine, pyridazine, pyrazine, pyrimidine, triazine, tetrazine, pyrrole, pyrazole, imidazole, triazole, tetrazole, oxadiazole, isoxazole, thiazole, isothiazole, oxadiazole, thiadiazole, quinoline, isoquinoline, cinnoline, phthalazine, quinoxaline, quinazoline, indole, indazole, benzimidazole, benzotriazole, benzoxazole, benzisoxazole, benzothiazole, benzisothiazole, benzoxadiazole, benzothiadiazole, saccharin, pyrrolidine, and piperidine.

In addition, examples of the above-described silylated heterocyclic compound include a silylated imidazole compound and a silylated triazole compound. An example of the silylated heterocyclic compound includes monomethylsilyl imidazole, dimethylsilyl imidazole, trimethylsilyl imidazole, monomethylsilyl triazole, dimethylsilyl triazole, or trimethylsilyl triazole.

It is noted that although the above-described silylated heterocyclic compound may correspond to the above-described silylating agent, the silylated heterocyclic compound is intended to mean that, in a case of being used as a catalytic compound, the silylated heterocyclic compound is used in combination with another silylating agent other than the silylated heterocyclic compound.

In the above-described silylation composition, a concentration of the silylating agent or a total concentration of the silylating agent and the catalytic compound may be, for example, 0.01% by mass to 100% by mass and is preferably 0.1% by mass to 50% by mass, and more preferably 0.5% by mass to 30% by mass with respect to 100% by mass of the silylation composition.

In addition, in a case where the silylation composition is a liquid, the silylation composition may contain a solvent.

The above-described solvent is not particularly limited as long as it dissolves the above-described silylating agent. As the solvent, for example, organic solvents such as hydrocarbons, esters, ethers, ketones, halogen element-containing solvents, sulfoxide-based solvents, alcohols, carbonate-based solvents, derivatives of polyhydric alcohol, nitrogen element-containing solvents, silicone solvents, and thiols are used. Among these, hydrocarbons, esters, ethers, halogen element-containing solvents, sulfoxide-based solvents, or derivatives of polyhydric alcohol having no OH group, are preferable.

These may be used alone, or two or more thereof may be used in combination.

Examples of the above-described hydrocarbons include linear, branched, or cyclic hydrocarbon-based solvents, aromatic hydrocarbon-based solvents, and terpene-based solvents, and specific examples thereof include n-hexane, n-heptane, n-octane, n-nonane, n-decane, n-undecane, n-dodecane, n-tetradecane, n-hexadecane, n-octadecane, n-icosane, branched hydrocarbon corresponding to the number of carbon atoms thereof (for example, isododecane, isocetane, and the like), cyclohexane, methylcyclohexane, decalin, benzene, toluene, xylene, (ortho-, meta-, or para-)diethylbenzene, 1,3,5-trimethylbenzene, naphthalene, mesitylene, p-menthane, o-menthane, m-menthane, diphenylmenthane, limonene, α-terpinene, β-terpinene, γ-terpinene, bornane, norbornane, pinane, α-pinene, β-pinene, carane, longifolene, abietane, and a terpene-based solvent.

Examples of the above-described esters include ethyl acetate, n-propyl acetate, i-propyl acetate, n-butyl acetate, i-butyl acetate, n-pentyl acetate, i-pentyl acetate, n-hexyl acetate, n-heptyl acetate, n-octyl acetate, n-pentyl formate, n-butyl propionate, ethyl butyrate, n-propyl butyrate, i-propyl butyrate, n-butyl butyrate, methyl n-octanate, methyl decanoate, methyl pyruvate, ethyl pyruvate, n-propyl pyruvate, methyl acetoacetate, ethyl acetoacetate, ethyl 2-oxobutanoate, dimethyl adipate, methyl 3-methoxypropionate, ethyl 3-methoxypropionate, methyl 3-ethoxypropionate, ethyl 3-ethoxypropionate, and ethyl ethoxyacetate.

In addition, as the above-described esters, cyclic esters such as a lactone compound may be used. Examples of the lactone compound include β-propiolactone, γ-butyrolactone, γ-valerolactone, γ-hexanolactone, γ-heptanolactone, γ-octanolactone, γ-nonanolactone, γ-decanolactone, γ-undecanolactone, γ-dodecanolactone, δ-valerolactone, δ-hexanolactone, δ-octanolactone, δ-nonanolactone, δ-decanolactone, δ-undecanolactone, δ-dodecanolactone, and ε-hexanolactone.

Examples of the above-described ethers include di-n-propyl ether, ethyl-n-butyl ether, di-n-butyl ether, ethyl-n-amyl ether, di-n-amyl ether, ethyl-n-hexyl ether, di-n-hexyl ether, di-n-octyl ether, diisopropyl ethers corresponding to the number of carbon atoms thereof, ethers with branched hydrocarbon groups, such as diisoamyl ether, dimethyl ether, diethyl ether, methyl ethyl ether, methyl cyclopentyl ether, diphenyl ether, tetrahydrofuran, and dioxane.

Examples of the above-described ketones include acetone, acetylacetone, methyl ethyl ketone, methyl propyl ketone, methyl butyl ketone, 2-heptanone, 3-heptanone, cyclohexanenone, and isophorone.

Examples of the above-described halogen element-containing solvent include perfluorocarbons such as perfluorooctane, perfluorononane, perfluorocyclopentane, perfluorocyclohexane, and hexafluorobenzene; hydrofluorocarbons such as 1,1,1,3,3-pentafluorobutane, octafluorocyclopentane, 2,3-dihydrodecafluoropentane, and ZEORORA H (manufactured by ZEON CORPORATION); hydrofluoroethers such as methyl perfluoropropyl ether, methyl perfluoroisobutyl ether, methyl perfluorobutyl ether, ethyl perfluorobutyl ether, ethyl perfluoroisobutyl ether, methyl perfluorohexyl ether, ethyl perfluorohexyl ether, Asahiklin AE-3000 (manufactured by AGC Inc.), Novec HFE-7100, Novec HFE-7200, Novec 7300, and Novec 7600 (all manufactured by 3M); chlorocarbons such as tetrachloromethane; hydrochlorocarbons such as chloroform; chlorofluorocarbons such as dichlorodifluoromethane; hydrochlorofluorocarbons such as 1,1-dichloro-2,2,3,3,3-pentafluoropropane, 1,3-dichloro-1,1,2,2,3-pentafluoropropane, 1-chloro-3,3,3-trifluoropropene, and 1,2-dichloro-3,3,3-trifluoropropene; perfluoroether, and perfluoropolyether.

Examples of the above-described sulfoxide-based solvent include dimethyl sulfoxide.

Examples of the above-described carbonate-based solvent include dimethyl carbonate, ethylmethyl carbonate, diethyl carbonate, and propylene carbonate.

Examples of the above-described alcohols include methanol, ethanol, 1-propanol, 2-propanol, 1-butanol, 2-butanol, isobutanol, tert-butanol, 1-pentanol, 2-pentanol, 3-pentanol, 2-methyl-1-butanol, 3-methyl-1-butanol, 2-methyl-2-butanol, 3-methyl-2-butanol, 1-hexanol, 2-hexanol, 3-hexanol, 2-methyl-1-pentanol, 3-methyl-1-pentanol, 4-methyl-1-pentanol, 2-methyl-2-pentanol, 3-methyl-2-pentanol, 4-methyl-2-pentanol, 2-methyl-3-pentanol, 3-methyl-3-pentanol, 2,2-dimethyl-1-butanol, 3,3-dimethyl-1-butanol, 3,3-dimethyl-2-butanol, 2-ethyl-1-butanol, 1-heptanol, 2-heptanol, 3-heptanol, 4-heptanol, benzyl alcohol, 1-octanol, isooctanol, 2-ethyl-1-hexanol, and 4-methyl-2-pentanol.

Examples of the derivative of the above-described polyhydric alcohol having no OH group include ethylene glycol dimethyl ether, ethylene glycol diethyl ether, ethylene glycol dibutyl ether, ethylene glycol monomethyl ether acetate, ethylene glycol monoethyl ether acetate, ethylene glycol monobutyl ether acetate, ethylene glycol diacetate, diethylene glycol dimethyl ether, diethylene glycol ethylmethyl ether, diethylene glycol diethyl ether, diethylene glycol butylmethyl ether, diethylene glycol dibutyl ether, diethylene glycol monomethyl ether acetate, diethylene glycol monoethyl ether acetate, diethylene glycol monobutyl ether acetate, diethylene glycol diacetate, triethylene glycol dimethyl ether, triethylene glycol diethyl ether, triethylene glycol dibutyl ether, triethylene glycol butylmethyl ether, triethylene glycol monomethyl ether acetate, triethylene glycol monoethyl ether acetate, triethylene glycol monobutyl ether acetate, triethylene glycol diacetate, tetraethylene glycol dimethyl ether, tetraethylene glycol diethyl ether, tetraethylene glycol dibutyl ether, tetraethylene glycol monomethyl ether acetate, tetraethylene glycol monoethyl ether acetate, tetraethylene glycol monobutyl ether acetate, tetraethylene glycol diacetate, propylene glycol dimethyl ether, propylene glycol diethyl ether, propylene glycol dibutyl ether, propylene glycol monomethyl ether acetate, propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, dipropylene glycol diacetate, tripropylene glycol dimethyl ether, tripropylene glycol diethyl ether, tripropylene glycol dibutyl ether, tripropylene glycol monomethyl ether acetate, tripropylene glycol monoethyl ether acetate, tripropylene glycol monobutyl ether acetate, tripropylene glycol diacetate, tetrapropylene glycol dimethyl ether, tetrapropylene glycol monomethyl ether acetate, tetrapropylene glycol diacetate, butylene glycol dimethyl ether, butylene glycol monomethyl ether acetate, butylene glycol diacetate, glycerin triacetate, 3-methoxybutyl acetate, 3-methyl-3-methoxybutyl acetate, and 3-methyl-3-methoxybutyl propionate.

Examples of the above-described nitrogen element-containing solvent include formamide, N,N-dimethylformamide, N,N-dimethylacetamide, N-methyl-2-pyrrolidone, N-ethyl-2-pyrrolidone, N-propyl-2-pyrrolidone, 1,3-dimethyl-2-imidazolidinone, 1,3-diethyl-2-imidazolidinone, 1,3-diisopropyl-2-imidazolidinone, diethylamine, triethylamine, and pyridine.

Examples of the above-described silicone solvent include hexamethyldisiloxane, octamethyltrisiloxane, decamethyltetrasiloxane, and dodecamethylpentasiloxane.

Examples of the above-described thiols include 1-hexanethiol, 2-methyl-1-pentanethiol, 3-methyl-1-pentanethiol, 4-methyl-1-pentanethiol, 2,2-dimethyl-1-butanethiol, 3,3-dimethyl-1-butanethiol, 2-ethyl-1-butanethiol, 1-heptanethiol, benzylthiol, 1-octanethiol, 2-ethyl-1-hexanethiol, 1-nonanethiol, 1-decanethiol, 1-undecanethiol, 1-dodecanethiol, and 1-tridecanethiol.

The above-described solvent preferably includes an aprotic solvent. The content of the aprotic solvent is, for example, 80% by mass or more, preferably 90% by mass or more in 100% by mass of the above-described solvent. It is more preferable that the above-described solvent is the aprotic solvent, that is, the solvent includes the aprotic solvent such that the content of the aprotic solvent is 100% by mass in 100% by mass in the solvent.

The aprotic solvent includes hydrocarbons, esters, ethers, ketones, halogen element-containing solvents, sulfoxides, carbonate solvents, derivatives of polyhydric alcohol, nitrogen element-containing solvents, and silicone solvents. These may be used alone, or two or more thereof may be used in combination.

Among these, it is preferable to use one or two or more kinds selected from the group consisting of derivatives of polyhydric alcohol, hydrocarbons, and ethers.

From the viewpoint of cost and solubility, a derivative of polyhydric alcohol (however, those having no OH group in the molecule) are preferable, and for example, diethylene glycol monoethyl ether acetate, ethylene glycol monomethyl ether acetate, propylene glycol monomethyl ether acetate, diethylene glycol dimethyl ether, diethylene glycol ethyl methyl ether, diethylene glycol diethyl ether, diethylene glycol monomethyl ether acetate, diethylene glycol diacetate, triethylene glycol dimethyl ether, ethylene glycol diacetate, ethylene glycol dimethyl ether, 3-methoxy-3-methyl-1-butyl acetate, propylene glycol dimethyl ether, propylene glycol diethyl ether, propylene glycol dibutyl ether, propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, or dipropylene glycol diacetate is preferable. In addition, propylene carbonate, a linear or branched hydrocarbon-based solvent having 6 to 12 carbon atoms, p-menthane, diphenylmenthane, limonene, terpinene, bornane, norbornane, pinane, or the like is also preferable.

As an example of the silylation composition containing a silylating agent and a solvent, for example, compositions in which the silylating agent includes one or two or more kinds selected from the group consisting of hexamethyldisilazane, heptamethyldisilazane, N-(trimethylsilyl)dimethylamine, bis(dimethylamino)dimethylsilane, bis(trimethylsilyl)trifluoroacetamide, N-methyl-N-trimethylsilyltrifluoroacetamide, N-trimethylsilylacetamide, N-trimethylsilylimidazole, trimethylsilyltriazole, bistrimethylsilylsulfate, 2,2,5,5-tetramethyl-2,5-disila-1-azacyclopentane, 2,2,4,4,6,6-hexamethylcyclotrisilazane, hexamethyldisiloxane, trimethylsilyltrifluoroacetate, trimethylsilyltrifluoromethanesulfonate, trimethylsilylbenzenesulfonate, and trimethylsilyltoluenesulfonate, and the solvent includes one or two or more kinds selected from the group consisting of propylene carbonate, linear hydrocarbon-based solvents having 7 to 10 carbon atoms, menthane, pinane, γ-butyrolactone, propylene glycol monomethyl ether acetate, and 3-methoxy-3-methyl-1-butylacetate may be used.

The silylation composition may not contain water or may contain water such that the content of water is 2% by mass or less in 100% by mass of the silylation composition. In this way, a silylation composition that is substantially free of water can be used.

The above-described silylation composition can contain a component other than the above-described components as long as the object of the present invention is not impaired. Examples of other components include oxidizing agents such as hydrogen peroxide and ozone, surfactants, and antioxidants such as BHT.

The silylation composition according to the present embodiment is obtained by mixing each of the components described above. The obtained mixed liquid may be purified using an adsorbent, a filter, or the like as necessary. In addition, each component may be purified in advance by distillation and also purified by using an adsorbent, a filter, or the like.

As described above, the embodiments according to the present invention have been described; however, these are examples according to the present invention, and thus it is possible to adopt various configurations other than the above. In addition, the present invention is not limited to the embodiments described above and modifications, improvements, and the like are included in the present invention in a range in which it is possible to achieve the object of the present invention.

Hereinafter, examples of the reference embodiments will be described.
1. A substrate processing method including:
   a preparation step of preparing a substrate in which at least a first surface containing silicon oxide and a second surface containing silicon nitride are exposed;
   a surface modification step of forming an etching selectivity imparting film on at least a part of the first surface and at least a part of the second surface by a silylation treatment of bringing a silylating agent into contact with the first surface and the second surface; and
   an etching step of selectively carrying out etching on the second surface with respect to the first surface using an etching agent after the surface modification step.
2. The substrate processing method according to 1., in which in the surface modification step, a first water contact angle on the etching selectivity imparting film on the first surface has a value larger than a value of a second water contact angle on the etching selectivity imparting film on the second surface.
3. The substrate processing method according to 2., in which a difference between the first water contact angle and the second water contact angle is 5° or more.
4. The substrate processing method according to any one of 1. to 3., further including:
   a cleaning step of carrying out cleaning by using a cleaning agent, between the surface modification step and the etching step.
5. The substrate processing method according to 4., in which a liquid temperature of the cleaning agent is 60°C or lower.
6. The substrate processing method according to 4. or 5., in which the cleaning agent includes an aqueous cleaning solution and/or a rinsing solution.
7. The substrate processing method according to any one of 4. to 6., in which a cycle including at least the surface modification step, the cleaning step, and the etching step in this order is carried out two or more times.
8. The substrate processing method according to any one of 1. to 7.,
   in which the surface modification step such that a pretreatment is carried out before the silylation treatment, and
   in which the pretreatment includes a treatment of increasing a difference between a first water contact angle on the etching selectivity imparting film on the first surface and a second water contact angle on the etching selectivity imparting film on the second surface.
9. The substrate processing method according to any one of 1. to 8., further including:
   a removal treatment of removing at least a part of the etching selectivity imparting film on the first surface, after the etching step.
10. The substrate processing method according to any one of 1. to 9., in which a cycle including at least the surface modification step and the etching step in this order is carried out two or more times.
11. The substrate processing method according to any one of 1. to 10., in which in the silylation treatment, the etching selectivity imparting film is formed using a silylation composition containing the silylating agent and a catalytic compound.
12. The substrate processing method according to any one of 1. to 11., in which in the silylation treatment, the silylating agent is used, or a silylation composition containing the silylating agent and at least one of a solvent, a dilution gas, or a catalytic compound is used.
13. A substrate manufacturing method including:
   each step in the substrate processing method according to any one of 1. to 12.

### Examples

Hereinafter, the present invention will be described in detail with reference to Examples; however, the present invention is not limited to the description of these Examples.

### [Examples 1 to 6]

A substrate was subjected to an etching treatment according to a method in <Treatment of substrate> below. The treatment conditions of each of Examples are shown in Table 1.

### <Treatment of substrate>

### (1. Preparation step for substrate)

As the substrate, a silicon substrate having a smooth surface and having a size of 30 mm × 40 mm × 1 mm was used.

A silicon oxide film or a silicon nitride film was formed on a surface of the substrate, the substrate on which the silicon oxide film was formed was regarded as the first surface, and the substrate on which the silicon nitride film was formed was regarded as the second surface.

In Table 1, the silicon oxide film is denoted as SiO and the silicon nitride film is denoted as SiN (however, the compositional ratio is not limited to Si:O = 1:1 or Si:N = 1:1). The following test is a simulation test using the substrate described above.

### (2. Surface modification step)

The prepared substrate was subjected to a surface modification treatment under the following treatment conditions in the order of the pretreatment A and the silylation treatment B**.** Treatment conditions for each treatment that is used in the surface modification step are as follows.

### (2.1) Pretreatment A

### (A-1) Removal of natural oxidation film

The substrate was immersed in an aqueous solution of 0.02% to 1% by mass of hydrofluoric acid (DHF) for 1 minute at room temperature, and subsequently immersed in pure water for 1 minute and then in 2-propanol (IPA) for 1 minute, as rinsing liquids.

### (2.2) Silylation treatment B

The substrate was immersed in the silylating agent B-1 prepared by the following method, at room temperature for 0.3 minutes, 1 minute, 5 minutes, or 10 minutes to carry out a silylation treatment on the surface of the substrate.

Next, the substrate was immersed in IPA for 1 minute. Thereafter, the substrate was taken out and dried by blowing nitrogen gas to remove the IPA (cleaning treatment).

### (Silylating agent B-1)

A silylating agent B-1 was obtained by weighing each of 5 g of hexamethyldisilazane (HMDS), 0.1 g of trimethylsilyl trifluoroacetate, and 94.9 g of propylene glycol monomethyl ether acetate (PGMEA) and then mixing them at room temperature.

### (Silylating agent B-2)

A silylating agent B-2 was obtained by weighing each of 12 g of 1,3-dioctyl-1,1,3,3-tetramethyldisilazane, 0.5 g of octyldimethylsilyltrifluoroacetate, and 87.5 g of PGMEA and then mixing them at room temperature.

### (Silylating agent B-3)

A silylating agent B-3 was obtained by weighing each of 12 g of HMDS, 4 g of trimethylsilyl trifluoroacetate, and 84 g of PGMEA and then mixing them at room temperature.

### (3. Etching step)

After (2. Surface modification step) described above, the substrate was immersed in an aqueous solution of 0.5% by mass of hydrogen fluoride for 1 minute, 3 minutes, or 5 minutes at room temperature (25°C) (etching treatment).

After the etching treatment, the substrate was immersed in pure water for 1 minute. Thereafter, the substrate was taken out and dried by blowing nitrogen gas to remove the water (cleaning treatment).

### [Comparative Examples]

The etching treatment and the cleaning treatment were carried out by the same method as in Example 1, except that the above-described silylation treatment B was not carried out and the etching treatment time was set to 1 minute or 3 minutes.

The following items were evaluated using the substrate in the treatment process or after the treatment of <Treatment of substrate> described above.

### [Table 1]

**Table 1**

| .SiO (first film) SiN (second film) | Silylating agent | Silylation treatment B | Water contact angle (°) immediately before etching treatment | | Water receding angle (°) immediately before etching treatment | | Etching time: 1 minute | | | Etching time: 3 minutes | | | Etching time: 5 minutes | | |
|---|---|---|---|---|---|---|---|---|---|---|---|---|---|---|---|
| | | | | | | | Etching amount (nm) | | Etching selection ratio | Etching amount (nm) | | Etching selection ratio | Etching amount (nm) | | Etching selection ratio |
| | | Treatment time (minutes) | SiO | SiN | SiO | SiN | SiO | SiN | SiN/SiO | SiO | SiN | SiN/SiO | SiO | SiN | SiN/SiO |
| Example 1 | B-1 | 1 | 86 | 53 | 81 | 48 | < 0.1 | 0.3 | 3 or more | 0.3 | 1.1 | 3.7 | 0.6 | 1.7 | 2.8 |
| Example 2 | B-1 | 5 | 90 | 57 | 85 | 52 | < 0.1 | 0.3 | 3 or more | < 0.1 | 0.9 | 9 or more | < 0.1 | 2.1 | 21 or more |
| Example 3 | B-1 | 10 | 92 | 59 | 87 | 54 | < 0.1 | 0.2 | 2 or more | < 0.1 | 0.6 | 6 or more | < 0.1 | 1.6 | 16 or more |
| Example 4 | B-2 | 1 | 95 | 56 | 70 | 51 | 0.1 | 0.2 | 2 | 0.4 | 2 | 5 | 1.1 | 2 | 1.8 |
| Example 5 | B-3 | 0.3 | 90 | 55 | 85 | 50 | < 0.1 | 0.7 | 7 or more | < 0.1 | 2 | 20 or more | < 0.1 | 2.3 | 23 or more |
| Example 6 | B-3 | 1 | 92 | 59 | 87 | 54 | < 0.1 | 0.3 | 3 or more | < 0.1 | 1.2 | 12 or more | < 0.1 | 1.2 | 12 or more |
| Comparative Example | Absent | 0 | 3 | 17 | < 1 | < 1 | 3.2 | 0.7 | 0.2 | 8.4 | 2.3 | 0.3 | - | | |

### <Measurement and evaluation of water contact angle>

### (Measurement of water contact angle)

The water contact angle (°) on the surface of the substrate immediately before the etching treatment was measured according to the following measurement procedure.

First, the substrate was immersed in IPA at 25°C for 1 minute. Next, the substrate was dried by blowing air thereon. Next, the surface of the substrate, which had been subjected to the treatment A, was placed horizontally with the surface facing upward, and a water droplet of 2 µl of pure water was placed on the surface. Next, in accordance with JIS R 3257:1999 "Testing method of wettability of surface of glass substrate", an angle (water contact angle) formed by a water droplet and the substrate was measured with a contact angle meter (manufactured by Kyowa Interface Science Co., Ltd.: CA-X type). In addition, the temperature during the measurement was set to room temperature (approximately 25°C).

### (Measurement of water receding angle)

According to the following procedure, the water receding angle (°) on the surface of the substrate immediately before the etching treatment was measured.

First, in a state of being allowed to stand on a horizontal table, 30 µl of pure water was dropped onto the surface of the surface-treated substrate at a room temperature of 25°C.

Next, the pure water is sucked at a rate of 6 µl/sec, a value of a water contact angle while the size of the liquid droplet is being reduced is measured, and the value is defined as a water receding angle (°). It is noted that the water contact angle indicates a value of a normal water contact angle (static contact angle) in the initial stage of suction; however, the water contact angle starts to change when the suction is started, and the amount of change in contact angle becomes small and indicates a substantially constant value in a case where the suction is further continued. For the water receding angle, the water contact angle at the time when the amount of change was small was used.

### <Etching amount and etching selectivity>

The film thickness of each of the silicon oxide film and the silicon nitride film formed on the substrate was measured using an ellipsometer (SE-2000 manufactured by Semilab Japan KK). The measurement of the film thickness was carried out for each of samples obtained by carrying out the silylation treatment B for 0.3 minutes, 1 minute, 5 minutes, or 10 minutes, and a sample without undergoing the silylation treatment, before the etching treatment (0 minutes) and after each etching treatment using the above-described immersion time. A difference in film thickness reduced from the initial film thickness (before the etching treatment) was calculated as the etching amount (nm). The results are shown in Table 1.

### [Example 7]

### <Treatment of substrate>

### (1. Preparation step for substrate)

As the substrate, a silicon substrate having a smooth surface and a size of 30 mm × 40 mm × 1 mm and a substrate on which a silicon oxide film was formed in the same manner as in Example 1 were used. The substrate on which the silicon oxide film was formed was regarded as the first surface, and the silicon substrate on which the silicon oxide film was not formed was regarded as the second surface.

### (2. Surface modification step)

The prepared substrate was subjected to a surface modification treatment under the following treatment conditions in the order of the pretreatment A and the silylation treatment B**.** Treatment conditions for each treatment that is used in the surface modification step are as follows.

### (2.1) Pretreatment A

### (A-1) Removal of natural oxidation film

The substrate was immersed in an aqueous solution of 1% by mass of hydrofluoric acid (DHF) for 1 minute at room temperature, and subsequently immersed in pure water for 1 minute and then in 2-propanol (IPA) for 1 minute, as rinsing liquids.

### (2.2) Silylation treatment B

The substrate was immersed in the silylating agent B-3 prepared by the above-described method at room temperature for 3 minutes, and the surface of the substrate was subjected to the silylation treatment. Next, the substrate was immersed in IPA for 1 minute. Thereafter, the substrate was taken out and dried by blowing nitrogen gas to remove the IPA (cleaning treatment).

### (3. Etching step)

First, the substrate after the (2. Surface modification step) was immersed in the following oxidizing agent (aqueous solution (NH₃:H₂O₂:water = 1:2:50) containing 0.5 wt% of NH₃ and 1.0 wt% of H₂O₂) at room temperature (25°C) for 1 minute. Next, the substrate was immersed in pure water for 1 minute (oxidation treatment). Next, the substrate after the oxidation treatment was immersed in an aqueous solution of 0.1% by mass of hydrogen fluoride for 1 minute at room temperature (25°C) (etching treatment).

After the etching treatment, the substrate was immersed in pure water for 1 minute. Thereafter, the substrate was taken out and dried by blowing nitrogen gas to remove the water (cleaning treatment).

The evaluation of the items shown in Table 2 was carried out using the substrate in the treatment process or after the treatment of <Treatment of substrate> described above. Each measuring method was the same as in Examples 1 to 6. The results are shown in Table 2.

### [Table 2]

**Table 2**

| SiO (first film) Si (second film) | Silylating agent | Silylation treatment B | Water contact angle (°) immediately before surface modification treatment | | Water receding angle (°) immediately after surface modification treatment | | Water contact angle (°) immediately after oxidization treatment (immediately before etching treatment) | | Etching time: 1 minute | | |
|---|---|---|---|---|---|---|---|---|---|---|---|
| | | | | | | | | | Etching amount (nm) | | Etching selection ratio |
| | | Treatment time (minutes) | SiO | Si | SiO | Si | SiO | Si | SiO | Si | Si/Si0 |
| Example 7 | B-3 | 3 | 95 | 88 | 90 | 81 | 83 | 8 | < 0.1 | 0.9 | 10 or more |

### <Evaluation of heating cleaning treatment>

The value (°) of each of the water contact angles before and after the cleaning treatment (immersion) under the conditions in Table 3 was measured based on the above-described method, in a case where the silicon nitride film (second surface) and the silicon oxide film (first surface) formed on the substrate immediately before the etching treatment was subjected to the silylation treatment was carried out and in a case where they were not subjected to the silylation treatment. As a result, it was found that, not only on the silicon oxide film (first surface) but also on the silicon nitride film (second surface), the water contact angle is relatively maintained by carrying out the silylation treatment, as compared with a case where the silylation treatment is not carried out, even in a case where the liquid temperature of the cleaning agent (DIW) is 40°C to 60°C, and thus it can be expected that the effect of the etching selectivity or the liquid draining properties is also maintained.

### [Table 3]

**Table 3**

| Substrate | Silylation treatment B | Cleaning treatment | Water contact angle (°) | |
|---|---|---|---|---|
| | | | Immediately after silylation treatment B | Immediately after cleaning treatment |
| SiN | Absent | 60°C, 5 minutes, DIW | 17 | 6 |
| | For 1 minute | 60°C, 5 minutes, DIW | 53 | 38 |
| | For 1 minute | 40°C, 10 minutes, DIW | 53 | 43 |
| SiO | Absent | 60°C, 5 minutes, DIW | < 5 | < 5 |
| | For 1 minute | 60°C, 5 minutes, DIW | 87 | 85 |
| | For 1 minute | 40°C, 10 minutes, DIW | 87 | 85 |

From the above results, it has been shown that the substrate processing method of each of Examples makes it possible to enhance the liquid draining properties immediately after the silylation treatment and makes it possible to enhance the etching selectivity during the etching treatment as compared with Comparative Example in which the substrate having the first surface containing silicon oxide and the second surface containing silicon nitride has not been subjected to the silylation treatment.

In addition, it was also shown that the liquid draining properties immediately after the silylation treatment are increased even in the substrate having the first surface containing silicon oxide and the second surface containing silicon, and by carrying out the oxidation treatment before the etching treatment, it is possible to enhance the etching selectivity during the etching treatment in the substrate having the first surface containing silicon oxide and the second surface containing silicon.

This application claims priority based on Japanese Patent Application No. 2022-090144 filed on June 2, 2022, and all contents of the disclosure are incorporated herein.

### REFERENCE SIGNS LIST

- 1: substrate
- 1a: substrate surface
- 11: first surface
- 12: second surface
- 20: silylating agent, silylation composition
- 21: water repellent film
- 22: water repellent film

## Claims

1. A substrate processing method comprising:
a preparation step of preparing a substrate in which at least a first surface containing silicon oxide and a second surface containing silicon or a silicon compound other than silicon oxide are exposed;
a surface modification step of forming an etching selectivity imparting film on at least a part of the first surface and at least a part of the second surface by a silylation treatment of bringing a silylating agent into contact with the first surface and the second surface; and
an etching step of selectively carrying out an etching treatment on the second surface with respect to the first surface using an etching agent after the surface modification step.

2. The substrate processing method according to Claim 1,
wherein the surface modification step such that a pretreatment is carried out before the silylation treatment, and
wherein the pretreatment includes a treatment of increasing a difference between a first water contact angle on the etching selectivity imparting film on the first surface and a second water contact angle on the etching selectivity imparting film on the second surface.

3. The substrate processing method according to Claim 1 or 2,
wherein in the preparation step, the substrate contains a silicon compound having an N element on the second surface, and
wherein the etching step is carried out, after the surface modification step, without carrying out an oxidation treatment of bringing an oxidizing agent into contact with the second surface.

4. The substrate processing method according to Claim 1 or 2,
wherein in the preparation step, the substrate contains, on the second surface, a silicon compound having at least one element selected from the group consisting of an N element, a C element, and a metal element, or contains silicon on the second surface, and
wherein the etching step is a step of carrying out, after the surface modification step, an oxidation treatment of bringing an oxidizing agent into contact with the second surface and then carrying out the etching treatment.

5. The substrate processing method according to any one of Claims 1 to 4,
wherein in the surface modification step, a first water contact angle on the etching selectivity imparting film on the first surface has a value larger than a value of a second water contact angle on the etching selectivity imparting film on the second surface.

6. The substrate processing method according to Claim 5,
wherein a difference between the first water contact angle and the second water contact angle is 5° or more.

7. The substrate processing method according to any one of Claims 1 to 6, further comprising:
a cleaning step of subjecting the first surface and the second surface to a cleaning treatment using a cleaning agent, between the surface modification step and the etching step.

8. The substrate processing method according to Claim 7,
wherein a liquid temperature of the cleaning agent is 60°C or lower.

9. The substrate processing method according to Claim 7 or 8,
wherein the cleaning agent includes an aqueous cleaning solution and/or a rinsing solution.

10. The substrate processing method according to any one of Claims 7 to 9,
wherein a cycle including at least the surface modification step, the cleaning step, and the etching step in this order is carried out two or more times.

11. The substrate processing method according to any one of Claims 1 to 10, further comprising:
a removal treatment of removing at least a part of the etching selectivity imparting film on the first surface, after the etching step.

12. The substrate processing method according to any one of Claims 1 to 11,
wherein a cycle including at least the surface modification step and the etching step in this order is carried out two or more times.

13. The substrate processing method according to any one of Claims 1 to 12,
wherein in the silylation treatment, the etching selectivity imparting film is formed using a silylation composition containing the silylating agent and a catalytic compound.

14. A substrate manufacturing method comprising:
each step in the substrate processing method according to any one of Claims 1 to 13.
